# EUROPEAN PATENT SPECIFICATION

(11) **EP 3 951 424 B1**
(45) Date of publication and mention of the grant of the patent: **01.07.2026**
(21) Application number: 19922913.9
(22) Date of filing: 04.07.2019
(51) Int. Cl.: G01S 7/481, G01S 17/88, G01S 7/484, G01S 17/04, G01S 17/10, G01S 17/894, G06F 1/16, G06V 20/64, G06V 40/16, H01S 5/183, H01S 5/20, H01S 5/42

(54) **LIGHT-EMITTING DEVICE, OPTICAL DEVICE, AND INFORMATION PROCESSING DEVICE**
LICHTEMITTIERENDE VORRICHTUNG, OPTISCHE VORRICHTUNG UND INFORMATIONSVERARBEITUNGSVORRICHTUNG
DISPOSITIF ÉLECTROLUMINESCENT, DISPOSITIF OPTIQUE ET DISPOSITIF DE TRAITEMENT D'INFORMATIONS

(30) Priority: 02.04.2019 JP 2019070390; 10.04.2019 JP 2019074540
(43) Date of publication of application: 09.02.2022
(73) Proprietor: Fujifilm Business Innovation Corp., Tokyo 107-0052 (JP)
(72) Inventor: KONDO, Takashi, Ebina-shi, Kanagawa 243-0494 (JP); INADA, Satoshi, Ebina-shi, Kanagawa 243-0494 (JP); MINAMIRU, Takeshi, Ebina-shi, Kanagawa 243-0494 (JP); SAKAI, Kazuhiro, Ebina-shi, Kanagawa 243-0494 (JP); SHIRAKAWA, Yoshinori, Ebina-shi, Kanagawa 243-0494 (JP)
(74) Representative: Meissner Bolte Partnerschaft mbB
(86) International application number: PCT/JP2019/026712
(87) International publication number: WO 2020/202592

(56) References cited:
- EP-A2- 3 078 499
- CN-A- 107 884 066
- CN-A- 107 884 066
- JP-A- 2013 093 571
- JP-A- 2014 036 027
- JP-A- 2016 200 808
- US-A1- 2013 083 304
- US-A1- 2014 044 438
- US-A1- 2018 129 866

## Description

### TECHNICAL FIELD

The present invention relates to a light-emitting device, an optical device, and an information processing device.

### BACKGROUND ART

Patent Literature 1 discloses an imaging device including: a light source; a diffusion plate that includes a plurality of lenses disposed adjacent to each other on a predetermined plane and diffuses light emitted from the light source; and an imaging element that receives reflected light generated reflecting the light diffused by the diffusion plate by a subject.

Here, the plurality of lenses are disposed such that a period of an interference pattern in the diffused light is three pixels or less.

CN107884066A discloses a light-emitting device, comprising a first light source and a second light source, wherein the second light source has a light output larger than a light output of the first light source and is driven independently from the first light source. Furthermore a light diffusion member is provided on an emission path of the second light source. EP3078499A2 relates to a Laser imaging system and explains that VCSEL devices are either single mode or multi-mode devices. Here ,the light emitting elements of multi-mode VCSEL devices have larger aperture sizes than those of single mode devices, and can produce higher maximum light output power.

### CITATION LIST

### PATENT LITERATURE

Patent Literature 1: JP-A-2018-54769

### SUMMARY OF INVENTION

### TECHNICAL PROBLEM

A configuration is known in which an object to be measured is irradiated with light emitted from a light source via a light diffusion member so as to measure a three-dimensional shape of the object to be measured.

In this case, from the viewpoint of energy saving and the like, a configuration including a light source for proximity detection that detects whether or not an object to be measured is within a predetermined distance, and a light source for three-dimensional measurement that diffusively irradiates, via a light diffusion member, the object to be measured with light having a light output higher than that of the light source for proximity detection may be considered.

Here, as the light source for proximity detection, it is desirable that the spread angle is not too wide such that the light density does not decrease too much on the irradiation surface of the object to be measured. On the other hand, as a light source for three-dimensional measurement, it is not desired that the spread angle is narrow since the light source is diffused and irradiated by a light diffusion member or the like, and it is rather desired that the light output is high.

Exemplary embodiments of the present disclosure relate to providing a light-emitting device and the like in which, in a configuration including a first light source and a second light source which has a light output larger than that of the first light source and is configured to be driven independently from the first light source, a decrease in light density on an irradiation surface of light emitted from the first light source is suppressed, compared to a configuration in which light is irradiated from the first light source at the same spread angle as the spread angle of the second light source used for diffusion irradiation.

### SOLUTION TO PROBLEM

[1] According to the invention, there is provided a light-emitting device including: a first light source that oscillates in a single lateral mode; a second light source oscillates in a multiple lateral mode, the second light source having a light output larger than a light output of the first light source and being configured to be driven independently from the first light source; and a light diffusion member that is provided on an emission path of the second light source.
[2] In the light-emitting device according to [1], the first light source may include at least one first vertical cavity surface emitting laser element, the second light source may include plural second vertical cavity surface emitting laser elements, and the light-emitting device may be driven such that a light output emitted from one of the first vertical cavity surface emitting laser element is smaller than a light output emitted from one of the second vertical cavity surface emitting laser element.
[3] In the light-emitting device according to [1], the first light source may include at least one first vertical cavity surface emitting laser element, the second light source may include plural second vertical cavity surface emitting laser elements, and the light-emitting device may be driven with a light output such that a power conversion efficiency of the first vertical cavity surface emitting laser element is lower than a power conversion efficiency of the second vertical cavity surface emitting laser element.
[4] In the light-emitting device according to [2] or [3], the first vertical cavity surface emitting laser element may be driven such that the light output of one of the first vertical cavity surface emitting laser elements is in a range of 1 mW or more and 4 mW or less.
[5] In the light-emitting device according to any one of [2] to [4], the second vertical cavity surface emitting laser element may be driven such that a light output of one of the second vertical cavity surface emitting laser elements is in a range of 4 mW or more and 8 mW or less.
[6] In the light-emitting device according to any one of [2] to [5], the first vertical cavity surface emitting laser element may have a length resonator structure having a cavity length of 5λ or more and 20λ or less when an oscillation wavelength is λ.
[7] According to another aspect of the present disclosure, there is provided an optical device including: the light-emitting device according to any one of [1] to [6]; and a light receiving unit that receives a first reflected light emitted from the first light source of the light-emitting device and reflected by the object to be measured and a second reflected light emitted from the second light source of the light-emitting device and reflected by the object to be measured, wherein the light receiving unit outputs a signal corresponding to a time from when light is emitted from the first light source to when the light from the first light source is received by the light receiving unit, and a signal corresponding to a time from when light is emitted from the second light source to when the light from the second light source is received by the light receiving unit.
[8] According to another aspect of the present disclosure, there is provided an optical device including: the light-emitting device according to any one of [1] to [6]; and a light receiving unit that receives a first reflected light emitted from the first light source of the light-emitting device and reflected by an object to be measured and a second reflected light emitted from the second light source of the light-emitting device and reflected by the object to be measured, wherein, in a case where the first reflected light indicates that the object to be measured is present within a predetermined distance, light may be emitted from the second light source.
[9] According to another aspect of the present disclosure, there is provided an information processing device including the optical device according to [7] or [8], and a shape specifying unit that specifies a three-dimensional shape of the object to be measured based on a second reflected light emitted from the second light source of the optical device and reflected by the object to be measured.
[10] The information processing device according to [9] may further include an authentication processing unit that performs authentication processing related to use of the information processing device based on a specification result by the shape specifying unit.

### ADVANTAGEOUS EFFECTS OF INVENTION

According to the light-emitting device described in [1], compared to a configuration in which light is irradiated from the first light source at the same spread angle as the spread angle of the second light source used for the diffusion irradiation, a decrease in the light density on the irradiation surface of the light emitted from the first light source is suppressed.

According to the light-emitting device described in [2], compared to the case where the light output of the first vertical cavity surface emitting laser element is matched with the light output of the second vertical cavity surface emitting laser element, the decrease in the light density on the irradiation surface of the light emitted from the first vertical cavity surface emitting laser element is suppressed.

According to the light-emitting device described in [3], compared to the case where the power conversion efficiency of the first vertical cavity surface emitting laser device is matched with the power conversion efficiency of the second vertical cavity surface emitting laser device, the decrease in the light density on the irradiation surface of the light emitted from the first vertical cavity surface emitting laser device is suppressed.

According to the light-emitting device described in [4], compared to a case where the light-emitting device is driven in a region exceeding 4 mW, light having a narrower spread angle is irradiated.

According to the light-emitting device described in [5], compared to the case where the light-emitting device is driven in a region of less than 4 mW, the power conversion efficiency of the second vertical cavity surface emitting laser element is improved.

According to the light-emitting device described in [6], compared to the case where the light-emitting device is constituted by a normal single mode vertical cavity surface emitting laser element in which the cavity length is matched with λ, the spread angle becomes narrower.

According to the optical device described in [7], both the proximity detection and the three-dimensional measurement can be performed.

According to the optical device described in [8], when the object to be measured is not present within a predetermined distance, no light is emitted from the second light source.

According to the information processing device described in [9], the three-dimensional shape can be measured.

According to the information processing device described in [10], the authentication processing function based on the three-dimensional shape can be equipped.

### BRIEF DESCRIPTION OF THE DRAWINGS

Fig. 1 is a diagram illustrating an example of an information processing device to which the exemplary embodiment is applied.
Fig. 2 is a block diagram illustrating a configuration of an information processing device.
Fig. 3 is a plan view and a cross-sectional view of an example of an optical device, (a) is a plan view, and (b) is a cross-sectional view taken along a line IIIB-IIIB in (a).
Fig. 4 is a diagram illustrating a configuration of a proximity detection light source and a 3D shape measurement light source.
Fig. 5 is a diagram illustrating a cross-sectional structure of one VCSEL in the proximity detection light source.
Fig. 6 is a diagram illustrating a cross-sectional structure of one VCSEL in a 3D shape measurement light source.
Fig. 7 is a diagram illustrating a relationship between a light output and the power conversion efficiency of a general VCSEL.
Fig. 8 is a view illustrating an example of a configuration of a diffusion plate, in which (a) is a plan view and (b) is a cross-sectional view taken along a line VIIIB-VIIIB in (a).
Fig. 9 is a view illustrating modifications of the diffusion plate, in which (a) is a view showing a first modification of the diffusion plate, and (b) is a view showing a second modification of the diffusion plate.
Fig. 10 is a diagram for explaining a 3D sensor.
Fig. 11 is a flowchart for performing authentication processing related to use of the information processing device.
Fig. 12 is a diagram for explaining low side driving.
Fig. 13 is a diagram for explaining a disposition of a proximity detection light source, a 3D shape measurement light source, and a light amount monitoring light receiving element in the light-emitting device, in which (a) illustrates the disposition described as the present embodiment, (b) illustrates a first modification of the disposition, (c) illustrates a second modification of the disposition, and (d) illustrates a third modification of the disposition.

### DESCRIPTION OF EMBODIMENTS

Hereinafter, exemplary embodiments of the present invention will be described in detail with reference to the accompanying drawings.

In many cases, an information processing device identifies whether a user who accesses the information processing device is permitted to access the information processing device, and permits use of the information processing device which is an own device, only when it is authenticated that the user is permitted to access the information processing device. So far, a method of authenticating the user by a password, a fingerprint, an iris, or the like has been used. Recently, there is a demand for an authentication method having higher security. As this method, authentication based on a three-dimensional image such as a shape of a face of the user is performed.

Here, the information processing device will be described as an example of a portable information processing terminal, and will be described as authenticating the user by recognizing the shape of the face captured as the three-dimensional image. The information processing device may be applied to an information processing device such as a personal computer (PC) other than the portable information processing terminal.

Further, configurations, functions, methods, and the like described in the present exemplary embodiment may be applied to recognition of a three-dimensional shape of an object other than the recognition of the shape of the face, and may also be applied to recognition of a shape of an object to be measured other than the face. Further, a distance to an object to be measured is not limited.

### [Information Processing Device 1]

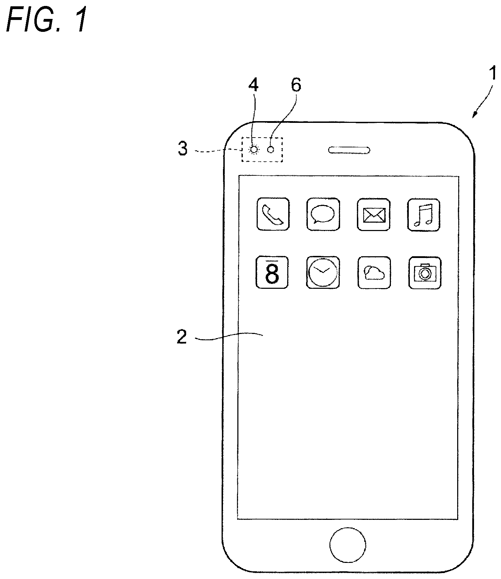

Fig. 1 is a diagram illustrating an example of an information processing device 1 to which the present exemplary embodiment is applied. As described above, the information processing device 1 is, for example, the portable information processing terminal as an example.

The information processing device 1 includes a user interface unit (hereinafter, referred to as a UI unit) 2 and an optical device 3 that acquires a three-dimensional image. The UI unit 2 is configured by integrating, for example, a display device that displays information to a user and an input device to which an instruction for information processing is input by an operation of the user. The display device is, for example, a liquid crystal display or an organic EL display, and the input device is, for example, a touch panel.

The optical device 3 includes a light-emitting device 4 and a three-dimensional sensor (hereinafter, referred to as a 3D sensor) 6. The light-emitting device 4 emits light toward an object to be measured, that is, a face in the example described here, in order to acquire a three-dimensional image. The 3D sensor 6 acquires light emitted by the light-emitting device 4, reflected by a face, and returned. Here, the three-dimensional image of the face is acquired based on a so-called TOF (Time of Flight) method based on a flight time of light. Hereinafter, even when the object to be measured is the face, the face is simply referred to as an object to be measured.

The information processing device 1 is configured as a computer including a central processing unit (CPU), a read only memory (ROM), a random access memory (RAM), and the like. The ROM includes a non-volatile rewritable memory, for example, a flash memory. The programs and constants stored in the ROM are loaded into the RAM and executed by the CPU, whereby the information processing device 1 operates, and various types of information processing are executed.

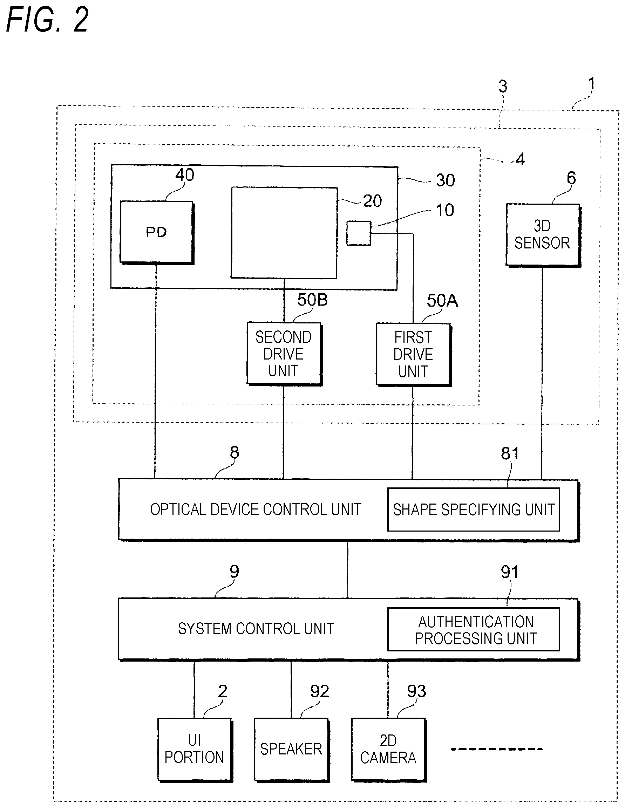

Fig. 2 is a block diagram illustrating a configuration of the information processing device 1.

The information processing device 1 includes the above-described optical device 3, an optical device control unit 8, and a system control unit 9. As described above, the optical device 3 includes the light-emitting device 4 and the 3D sensor 6. The optical device control unit 8 controls the optical device 3. The optical device control unit 8 includes a shape specifying unit 81. The system control unit 9 controls the whole information processing device 1 as a system. The system control unit 9 includes an authentication processing unit 91. The UI unit 2, a speaker 92, a two-dimensional (2D) camera 93, and the like are connected to the system control unit 9. The 3D sensor 6 is an example of a light receiving unit.

Hereinafter, the above components will be described in order.

As described above, the optical device 3 includes the light-emitting device 4 and the 3D sensor 6. The light-emitting device 4 may be referred to as a proximity detection light source 10, a 3D shape measurement light source 20, a diffusion plate 30, a light amount monitoring light receiving element (denoted as PD in Fig. 2) 40, a first drive unit 50A, and a second drive unit 50B. The proximity detection light source 10 is an example of a first light source, the 3D shape measurement light source 20 is an example of a second light source, and the diffusion plate 30 is an example of a light diffusion member.

The first drive unit 50A of the light-emitting device 4 drives the proximity detection light source 10, and the second drive unit 50B drives the 3D shape measurement light source 20. For example, the proximity detection light source 10 and the 3D shape measurement light source 20 are driven so as to emit pulsed light (hereinafter, referred to as an emitted light pulse) of several tens of MHz or more and several hundreds of MHz or less.

As will be described later, the optical device 3 is configured such that the 3D sensor 6 receives reflected light from an object to be measured with respect to light emitted from each of the proximity detection light source 10 and the 3D shape measurement light source 20 toward the object to be measured.

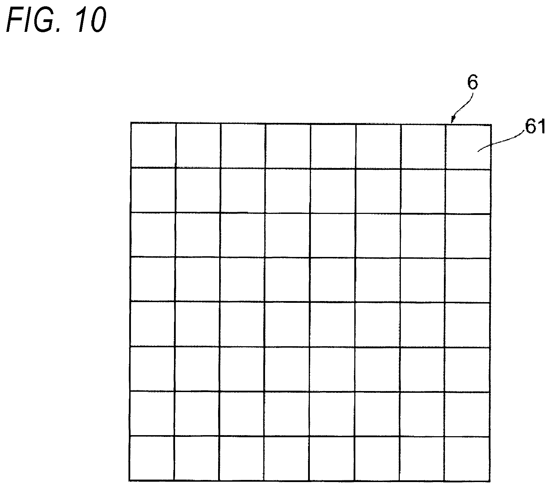

The 3D sensor 6 includes plural light receiving regions 61 (see Fig. 10 to be described later). The 3D sensor 6 outputs a signal corresponding to a time from when the light emitted from the proximity detection light source 10 is emitted to when the light is reflected by the object to be measured and received by the 3D sensor 6, and a signal corresponding to a time from when the light emitted from the 3D shape measurement light source 20 is emitted to when the light is reflected by the object to be measured and received by the 3D sensor 6. The 3D sensor 6 may include a condensing lens.

The light irradiated from the proximity detection light source 10 and reflected from the object to be measured is an example of the first reflected light, and the light irradiated from the 3D shape measurement light source 20 and reflected from the object to be measured is an example of the second reflected light.

The shape specifying unit 81 of the optical device control unit 8 acquires, from the 3D sensor 6, a digital value obtained for each light receiving region 61, and calculates a distance to the object to be measured for each light receiving region 61, and specifies a 3D shape of the object to be measured.

The authentication processing unit 91 of the system control unit 9 performs authentication processing related to use of the information processing device 1 when the 3D shape of the object to be measured that is a specification result specified by the shape specifying unit 81 is a 3D shape stored in advance in the ROM or the like. The authentication processing related to the use of the information processing device 1 is, for example, processing as to whether or not to permit the use of the information processing device 1 that is an own device. For example, when the 3D shape of the face that is the object to be measured matches the face shape stored in a storage member such as a ROM, the use of the information processing device 1 that is the own device including the various applications and the like provided by the information processing device 1 is permitted.

The shape specifying unit 81 and the authentication processing unit 91 are configured by, for example, a program. Further, the shape specifying unit 81 and the authentication processing unit 91 may be configured by an integrated circuit such as an application specific integrated circuit (ASIC) or a field-programmable gate array (FPGA). The shape specifying unit 81 and the authentication processing unit 91 may be configured by software such as a program and an integrated circuit.

In Fig. 2, the optical device 3, the optical device control unit 8, and the system control unit 9 are separately shown, but the system control unit 9 may include the optical device control unit 8. Further, the optical device control unit 8 may be provided in the optical device 3. Further, the optical device 3, the optical device control unit 8, and the system control unit 9 may be configured integrally.

### (Overall Configuration of Optical Device 3)

Next, the optical device 3 will be described in detail.

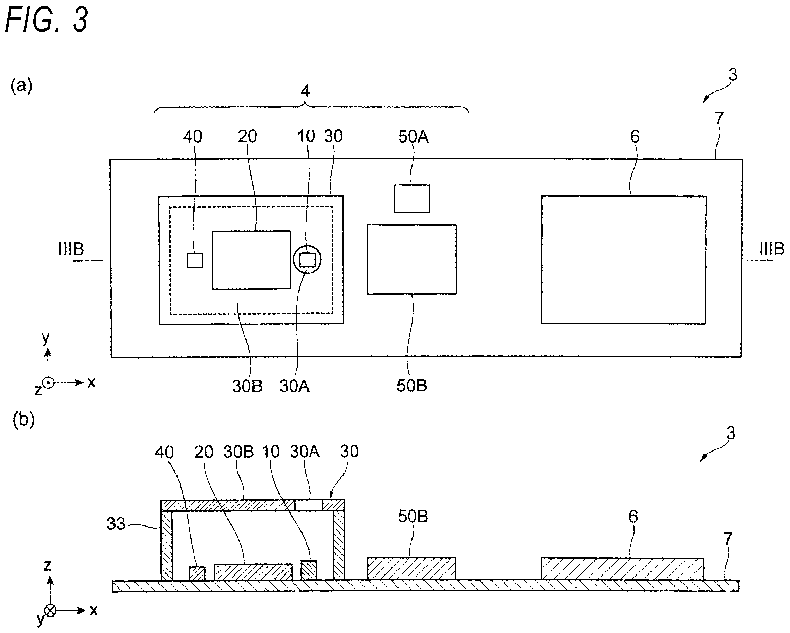

Fig. 3 is a plan view and a cross-sectional view of an example of the optical device 3. In Fig. 3, (a) is a plan view, and (b) is a cross-sectional view taken along a line IIIB-IIIB in (a). Here, in (a) of Fig. 3, a horizontal direction of a paper surface is defined as an x direction, and an upward direction of the paper surface is defined as a y direction. A direction orthogonal to the x direction and the y direction in a counterclockwise direction is defined as a z direction.

As illustrated in (a) of Fig. 3, in the optical device 3, the light-emitting device 4 and the 3D sensor 6 are disposed in the x direction on a circuit board 7. The circuit board 7 uses a plate-shaped member made of an insulation material as a base material, and is provided with conductor patterns made of a conductive material. The insulation material is made of, for example, ceramic, an epoxy resin, or the like. The circuit board 7 is provided with the conductor patterns made of a conductive material. The conductive material is, for example, a metal such as copper (Cu) or silver (Ag), or a conductive paste containing these metals. The circuit board 7 may be a single-layer board having conductor patterns provided on a front surface thereof, or may be a multilayer board having plural layers of conductor patterns. Further, the light-emitting device 4 and the 3D sensor 6 may be disposed on different circuit boards.

In the light-emitting device 4, the light amount monitoring light receiving element 40, the 3D shape measurement light source 20, the proximity detection light source 10, the first drive unit 50A, and the second drive unit 50B are disposed in order in the +x direction on the circuit board 7.

The proximity detection light source 10 and the 3D shape measurement light source 20 each have a quadrangle shape in a plan view, that is, a planar shape, and emit light in the same direction (the z direction in (b) of Fig. 3). The planar shape of each of the proximity detection light source 10 and the 3D shape measurement light source 20 may not be a quadrangle. The proximity detection light source 10 and the 3D shape measurement light source 20 may be directly mounted on the circuit board 7, or may be mounted on the circuit board 7 via a heat dissipation base material such as aluminum oxide or aluminum nitride. In the following description, it is assumed that the proximity detection light source 10 and the 3D shape measurement light source 20 are directly mounted on the circuit board 7. Hereinafter, the plan view means to be viewed from the z direction in (a) of Fig. 3.

The first drive unit 50A that drives the proximity detection light source 10 and the second drive unit 50B that drives the 3D shape measurement light source 20 are laterally disposed side by side in the y direction on the circuit board 7. A rated output of the first drive unit 50A is set to be smaller than a rated output of the second drive unit 50B. Therefore, an outer size of the first drive unit 50A is smaller than an outer size of the second drive unit 50B. The second drive unit 50B needs to drive the 3D shape measurement light source 20 with a large current. Therefore, the second drive unit 50B is disposed more preferentially than the first drive unit 50A such that the distance from the second drive unit 50B to the 3D shape measurement light source 20 is shortened. That is, the second drive unit 50B is disposed such that the wiring connected to the 3D shape measurement light source 20 has a wide pattern width. On the other hand, the first drive unit 50A is disposed at a position shifted laterally from the second drive unit 50B, that is, on the +y direction side of the second drive unit 50B.

The proximity detection light source 10 is disposed between the 3D shape measurement light source 20 and the second drive unit 50B on the circuit board 7. The light amount monitoring light receiving element 40 is disposed on the circuit board 7 at a position close to the 3D shape measurement light source 20, that is, on a side opposite to a position where the second drive unit 50B is disposed with respect to the 3D shape measurement light source 20. In this way, by disposing the proximity detection light source 10, the 3D shape measurement light source 20, and the light amount monitoring light receiving element 40 close to each other, these components may be easily covered with a common diffusion plate 30. On the other hand, in the case where the proximity detection light source 10 and the 3D shape measurement light source 20 are disposed at a distance from each other, in order to cover these components with the common diffusion plate 30, a diffusion plate 30 having a large size is required.

As illustrated in (a) of Fig. 3, a planar shape of the diffusion plate 30 is, for example, a rectangular shape. The planar shape of the diffusion plate 30 may not be a rectangular shape. As illustrated in (b) of Fig. 3, the diffusion plate 30 is provided at a predetermined distance from the proximity detection light source 10 and the 3D shape measurement light source 20. The diffusion plate 30 is supported by a spacer 33 on a light emission direction side of the proximity detection light source 10 and the 3D shape measurement light source 20. The diffusion plate 30 is provided so as to cover the proximity detection light source 10, the 3D shape measurement light source 20, and the light amount monitoring light receiving element 40. The spacer 33 is provided so as to surround the proximity detection light source 10, the 3D shape measurement light source 20, and the light amount monitoring light receiving element 40. When the spacer 33 is configured by a member that absorbs light emitted from the proximity detection light source 10 and the 3D shape measurement light source 20, light emitted from the proximity detection light source 10 and the 3D shape measurement light source 20 is suppressed from being irradiated to the outside through the spacer 33. In addition, by sealing the proximity detection light source 10, the 3D shape measurement light source 20, and the like by the diffusion plate 30 and the spacer 33, dust-proof, moisture-proof, and the like may be achieved. In the present exemplary embodiment, by disposing the proximity detection light source 10, the 3D shape measurement light source 20, and the light amount monitoring light receiving element 40 close to each other, the proximity detection light source 10, the 3D shape measurement light source 20, and the light amount monitoring light receiving element 40 are easily enclosed by a spacer 33 having a small size. On the contrary, in the case where the proximity detection light source 10 and the 3D shape measurement light source 20 are disposed at a distance from each other, when those components are surrounded by the common spacer 33, a space 33 having a large size is required. When two spacers 33 having small size are prepared, and the proximity detection light source 10 and the 3D shape measurement light source 20 are separately surrounded, the number of components increases twice. Since the spacer 33 is not provided between the proximity detection light source 10 and the 3D shape measurement light source 20, the size of the light-emitting device 4 is reduced as compared with the configuration in which the spacer 33 is provided between the proximity detection light source 10 and the 3D shape measurement light source 20.

The light amount monitoring light receiving element 40 is, for example, a photodiode (PD) made of silicon or the like that outputs an electric signal corresponding to a received light amount.

The light amount monitoring light receiving element 40 receives the light emitted from the 3D shape measurement light source 20 and reflected by the back surface of the diffusion plate 30, that is, the -z direction side surface. The light amount monitoring light receiving element 40 may receive light emitted from the proximity detection light source 10 and reflected by the back surface of the diffusion plate 30.

The 3D shape measurement light source 20 is controlled by the second drive unit 50B via the optical device control unit 8 so as to maintain a predetermined light output according to the light amount (received light amount) received by the light amount monitoring light receiving element 40.

When the received light amount of the light amount monitoring light receiving element 40 is extremely lowered, the diffusion plate 30 may be detached or damaged, the light emitted by the 3D shape measurement light source 20 may be directly irradiated to the outside. In such a case, the light output of the 3D shape measurement light source 20 is suppressed by the second drive unit 50B via the optical device control unit 8. For example, the radiation of light from the 3D shape measurement light source 20 is stopped.

In the light-emitting device 4, the proximity detection light source 10 is driven by the first drive unit 50A to emit light for detecting the proximity of the object to be measured. The 3D shape measurement light source 20 is driven by the second drive unit 50B to emit light for measuring the 3D shape of the object to be measured. The light amount monitoring light receiving element 40 receives the light reflected by the diffusion plate 30 among the light emitted from the 3D shape measurement light source 20, and monitors the light output of the 3D shape measurement light source 20. Then, the light output of the 3D shape measurement light source 20 is controlled via the second drive unit 50B based on the light output of the 3D shape measurement light source 20 monitored by the light amount monitoring light receiving element 40. The light amount monitoring light receiving element 40 may monitor the light output of the proximity detection light source 10 similarly to the 3D shape measurement light source 20.

### (Configurations of Proximity Detection Light Source 10 and 3D Shape Measurement Light Source 20)

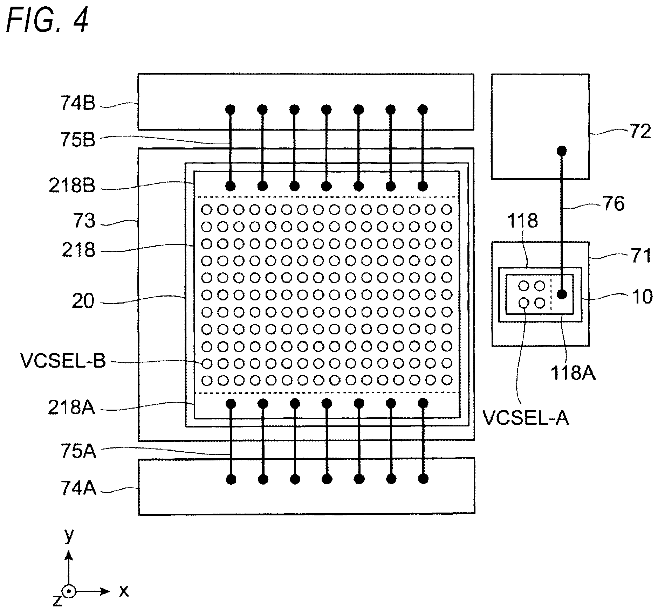

Fig. 4 is a diagram illustrating the configuration of the proximity detection light source 10 and the 3D shape measurement light source 20. The proximity detection light source 10 includes a vertical cavity surface emitting laser element VCSEL (vertical cavity surface emitting laser) -A. On the other hand, the 3D shape measurement light source 20 includes a vertical cavity surface emitting laser element VCSEL-B. Hereinafter, the vertical cavity surface emitting laser element VCSEL-A is referred to as a VCSEL-A, and the vertical cavity surface emitting laser element VCSEL-B is referred to as a VCSEL-B. When the VCSEL-A and the VCSEL-B are not distinguished from each other, the VCSEL-A and the VCSEL-B are referred to as the VCSEL. The VCSEL-A is an example of a first vertical cavity surface emitting laser element, and the VCSEL -B is an example of a second vertical cavity surface emitting laser element.

The VCSEL is a light-emitting element in which an active region serving as a light-emitting region is provided between a lower multilayer reflector and an upper multilayer reflector stacked on a substrate, and a laser beam is emitted in a direction perpendicular to the substrate. Therefore, the VCSEL may be easily arranged in a two-dimensional array. Here, it is assumed that the proximity detection light source 10 includes one or more VCSELs-A, and the 3D shape measurement light source 20 includes plural VCSELs-B.

The VCSEL-A of the proximity detection light source 10 emits light for detecting whether the object to be measured is close to the information processing device 1. The VCSEL-B of the 3D shape measurement light source 20 emits light for measuring the 3D shape of the object to be measured. When face authentication is taken as an example, a measurement distance is about 10 cm to 1 m. A range in which the 3D shape of the object to be measured is measured (hereinafter, referred to as a measurement range or an irradiation range, and this range is referred to as an irradiation surface) is about 1 m square.

In this case, the number of VCSELs-A included in the proximity detection light source 10 is 1 or more and 50 or less. The number of VCSELs-B included in the 3D shape measurement light source 20 is 100 or more and 1000 or less. That is, the number of the VCSELs-B of the 3D shape measurement light source 20 is larger than the number of the VCSELs-A of the proximity detection light source 10. As will be described later, the plurality of VCSELs-A of the proximity detection light source 10 are connected in parallel to each other and driven in parallel. Similarly, the plural VCSELs-B of the 3D shape measurement light source 20 are connected in parallel to each other and driven in parallel. The number of the VCSELs described above is an example, and may be set according to the measurement distance or the measurement range. The proximity detection light source 10 illustrated in Fig. 4 includes, for example, four VCSELs-A.

The proximity detection light source 10 is not required to irradiate the entire surface of the measurement range with light, and may detect whether or not the object to be measured is close to the measurement range. Therefore, the proximity detection light source 10 may irradiate a part of the measurement range with light. Therefore, the number of the VCSELs-A of the proximity detection light source 10 may be small. In order to detect whether or not the object to be measured is close to the information processing device 1, the proximity detection light source 10 irradiates the measurement range with light at a predetermined cycle when there is a request to use the information processing device 1. Therefore, the proximity detection light source 10 is required to have low power consumption.

On the other hand, when it is detected that the object to be measured is close to the measurement range, the 3D shape measurement light source 20 irradiates the entire surface of the measurement range with light. The 3D shape is specified based on reflected light received by the 3D sensor 6 from the measurement range. Therefore, the VCSEL-B of the 3D shape measurement light source 20 is required to have a large emitted light amount. The 3D shape measurement light source 20 includes a large number of VCSELs-B in order to uniformly irradiate the entire surface of the measurement range. The 3D shape measurement light source 20 emits light only when measuring the 3D shape, and thus allowed to have a high power consumption.

### (Structure of VCSEL-A of Proximity Detection Light Source 10)

Next, the structure of the VCSEL-A of the proximity detection light source 10 will be described.

The proximity detection light source 10 emits light in order to detect whether or not the object to be measured is close. Therefore, the VCSEL-A of the proximity detection light source 10 may have a low output, and the light density at a predetermined distance preferably has a predetermined value. That is, the VCSEL-A of the proximity detection light source 10 may have a low power consumption and a light density at which the reflected light from the object to be measured is reliably detected by the 3D sensor 6. Therefore, the VCSEL-A is required to have a small spread angle of the emitted light and a small decrease in the light density with respect to the distance.

The light density means irradiance.

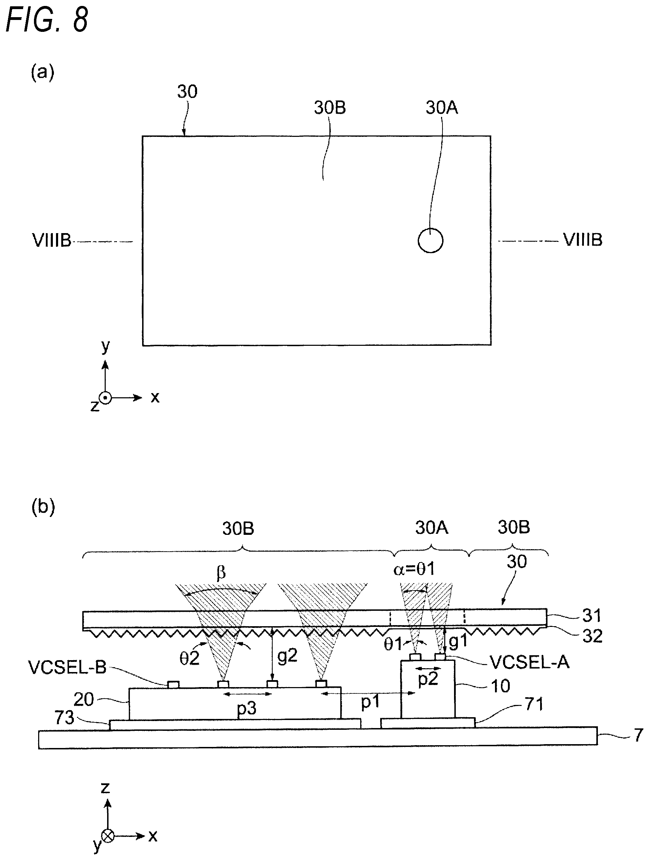

Here, as an example, a single-mode VCSEL that oscillates in a single transverse mode, that is, in a single mode, is used as the VCSEL-A of the proximity detection light source 10. The single-mode VCSEL has a spread angle of emitted light smaller than that of a multi-mode VCSEL that oscillates in multiple transverse modes, that is, in multi-modes. Therefore, even when the light outputs are the same, the single-mode VCSEL has a higher light density on an irradiation surface than the multi-mode VCSEL. The spread angle of the emitted light means full width at half maximum (FWHM) of the light emitted from the VCSEL (see θ1 and θ2 in (b) of Fig. 8). Here, the single transverse mode means a mode in which the intensity profile of the emitted light with the spread angle as a parameter has a unimodal characteristic, that is, a characteristic in which the number of the intensity peak is one. For example, plural transverse modes may be included in a range in which the unimodal characteristic is maintained.

The VCSEL-A of the proximity detection light source 10 may be configured by using a VCSEL having a long cavity structure as a single-mode VCSEL.

The VCSEL having the long cavity structure increases a loss in a higher-order transverse mode by introducing, between an active region in a VCSEL having a general λ resonator structure in which a cavity length is an oscillation wavelength λ and one multilayer film reflector, a spacer layer of several λ to several tens of λ to increase the cavity length. As a result, the VCSEL having the long cavity structure enables single-mode oscillation having an oxidation aperture diameter larger than an oxidation aperture diameter of the VCSEL having the general λ resonator structure. In a VCSEL having a typical λ resonator structure, since a longitudinal mode interval (sometimes called a free spectrum range) is large, a stable operation may be obtained in a single longitudinal mode. In contrast, in the case of the VCSEL having the long cavity structure, as the cavity length increases, a longitudinal mode interval is narrowed, and plural standing waves in the longitudinal mode are present in the resonator, and as a result, switching between the longitudinal modes is likely to occur. Therefore, in the VCSEL having the long cavity structure, it is required to prevent the switching between the longitudinal modes.

The VCSEL having the long cavity structure is easier to have a smaller spread angle than the single-mode VCSEL having the general λ resonator structure.

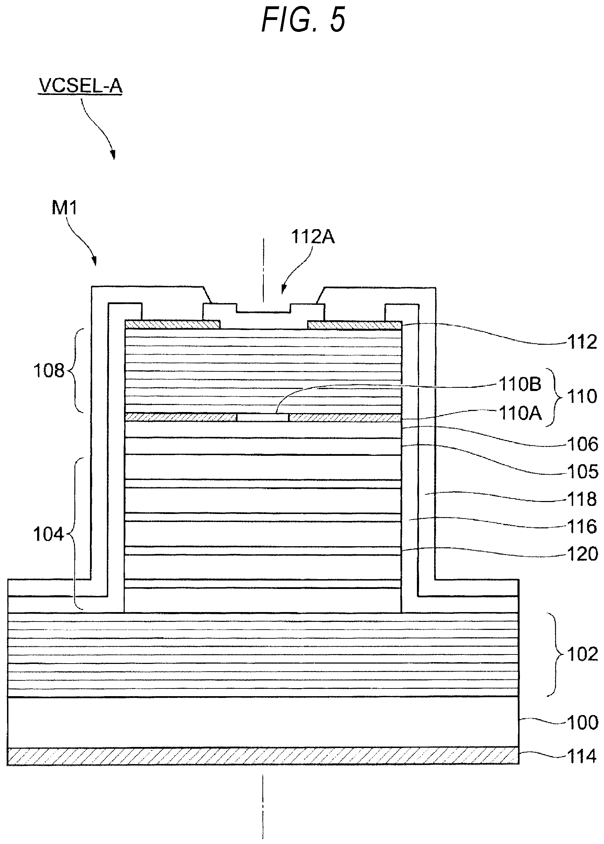

Fig. 5 is a diagram illustrating a cross-sectional structure of one VCSEL-A in the proximity detection light source 10. The VCSEL-A is the VCSEL having the long cavity structure.

The VCSEL-A is configured by stacking, on an n-type GaAs substrate 100, an n-type lower distributed bragg reflector (DBR) 102 in which AlGaAs layers having different Al compositions are alternately stacked, a resonator extension region 104 formed on the lower DBR 102 and extending the cavity length, an n-type carrier block layer 105 formed on the resonator extension region 104, an active region 106 formed on the carrier block layer 105 and including a quantum well layer sandwiched between an upper spacer layer and a lower spacer layer, and a p-type upper DBR 108 formed on the active region 106 in which AlGaAs layers having different Al compositions are alternately stacked.

The n-type lower DBR 102 is a multilayer stacked body in which an Al_{0.9}Ga_{0.1}As layer and a GaAs layer are paired, and a thickness of each layer is λ/4nᵣ (in which λ is an oscillation wavelength and nᵣ is a refractive index of a medium), these layers are alternately stacked in 40 cycles. A carrier concentration after doping with silicon that is an n-type impurity is, for example, 3 × 10¹⁸ cm⁻³.

The resonator extension region 104 is a monolithic layer formed by a series of epitaxial growth. The resonator extension region 104 is made of AlGaAs, GaAs, or AlAs such that the lattice constant of the resonator extension region 104 coincides or matches the lattice constant of the GaAs substrate. In order to emit a laser beam in a 940 nm band, the resonator extension region 104 is made of AlGaAs that does not cause light absorption. A film thickness of the resonator extension region 104 is set to 2 µm or more and 5 µm or less, and 5λ or more and 20λ or less based on the oscillation wavelength λ. Therefore, a movement distance of a carrier is increased. Therefore, the resonator extension region 104 is desired to be an n-type having large carrier mobility, and thus is inserted between the n-type lower DBR 102 and the active region 106. Such a resonator extension region 104 may be referred to as a cavity extension region or a cavity space.

Preferably, a carrier block layer 105 having a large band gap and is made of, for example, Al_{0.9}Ga_{0.1}As is formed between the resonator extension region 104 and the active region 106. By inserting the carrier block layer 105, a carrier leakage from the active region 106 is prevented, and light emission efficiency is improved. As will be described later, since an optical loss causing layer 120 in which an oscillation intensity of a laser beam is slightly attenuated is inserted into the resonator extension region 104, the carrier block layer 105 plays a role of compensating for such a loss. For example, the film thickness of the carrier blocking layer 105 is λ/4 mnᵣ (where λ is an oscillation wavelength, m is an integer, nᵣ is a refractive index of a medium).

The active region 106 is configured by stacking the lower spacer layer, the quantum well active layer, and the upper spacer layer. For example, the lower spacer layer is an undoped Al_{0.6}Ga_{0.4}As layer, the quantum well active layer is an undoped InGaAs quantum well layer and an undoped GaAs barrier layer, and the upper spacer layer is an undoped Al_{0.6}Ga_{0.4}As layer.

The p-type upper DBR 108 is a stacked body of a p-type Al_{0.9}Ga_{0.1}As layer and a GaAs layer, a thickness of each layer is λ/4nᵣ, and these layers are alternately stacked in 29 cycles. A carrier concentration after doping with carbon that is a p-type impurity is, for example, 3 × 10¹⁸ cm⁻³. Preferably, a contact layer made of p-type GaAs is formed in an uppermost layer of the upper DBR 108, and a current confinement layer 110 of p-type AlAs is formed on a lowermost layer of the upper DBR 108 or inside thereof.

By etching semiconductor layers stacked from the upper DBR 108 to the lower DBR 102, a columnar mesa M1 is formed on the substrate 100, and the current confinement layer 110 is exposed to a side surface of the mesa M1. In the current confinement layer 110, an oxidized region 110A selectively oxidized from the side surface of the mesa M1 and a conductive region 110B surrounded by the oxidized region 110A are formed. The conductive region 110B is an oxidized aperture. In an oxidation step, an AlAs layer has a higher oxidation rate than an AlGaAs layer, and the oxidized region 110A is oxidized from the side surface toward inside of the mesa M1 at a substantially constant rate, and thus a planar shape of the conductive region 110B parallel to the substrate is a shape that reflects an outer shape of the mesa M1, that is, a circular shape, and a center of the shape substantially coincides with an axis direction of the mesa M1 indicated by a dashed-dotted line. In the VCSEL-A having the long cavity structure, a diameter of the conductive region 110B for obtaining the single transverse mode may be made larger than that of a VCSEL having a normal λ resonator structure, and for example, the diameter of the conductive region 110B may be increased to about 7 µm or more and 8 µm or less.

An annular p-side electrode 112 made of metal in which Ti/Au or the like is stacked is formed on an uppermost layer of the mesa M1. The p-side electrode 112 is in ohmic contact with the contact layer of the upper DBR 108. An inner side of the annular p-side electrode 112 serves as a light emission port 112A through which a laser beam is emitted to the outside. That is, the central axis direction of the mesa M1 becomes the optical axis. Further, a cathode electrode 114 is formed as an n-side electrode on a back surface of the substrate 100. A front surface of the upper DBR 108 including the light emission port 112A is an emission surface.

Then, an insulating layer 116 is provided so as to cover a front surface of the mesa M1 except for a portion where the p-side electrode 112 and an anode electrode 118 to be described later are connected and the light emission port 112A. Further, the anode electrode 118 is provided so as to be in ohmic contact with the p-side electrode 112 except for the light emission port 112A. The anode electrode 118 is provided at a position except for a position of the light emission port 112A of each of the plural VCSELs-A. That is, in the plural VCSELs-A of the proximity detection light source 10, the respective p-side electrodes 112 are connected in parallel by the anode electrode 118.

In a VCSEL having a long cavity structure, since plural longitudinal modes may be present in a reflection band defined by a cavity length, it is required to suppress switching or popping between the longitudinal modes. Here, the oscillation wavelength band of a required longitudinal mode is set to 940 nm, and in order to prevent switching to an oscillation wavelength bands of a longitudinal mode other than the required longitudinal mode, the optical loss causing layer 120 with respect to a standing wave of an unnecessary longitudinal mode is provided in the resonator extension region 104. That is, the optical loss causing layer 120 is introduced at a position of a node of a standing wave in the required longitudinal mode. The optical loss causing layer 120 is made of a semiconductor material having the same Al composition as a semiconductor layer constituting the resonator extension region 104, and is made of, for example, Al_{0.3}Ga_{0.7}As. The optical loss causing layer 120 preferably has a higher impurity doping concentration than the semiconductor layer constituting the resonator extension region 104. For example, when an impurity concentration of AlGaAs constituting the resonator extension region 104 is 1 × 10¹⁷ cm⁻³, the optical loss causing layer 120 has an impurity concentration of 1 × 10¹⁸ cm⁻³, and is configured such that the impurity concentration is higher by about one order of magnitude than that of other semiconductor layers. When the impurity concentration is increased, absorption of light by a carrier is increased, which causes a loss. A film thickness of the optical loss causing layer 120 is selected so as not to increase a loss to the required longitudinal mode, and is preferably about the same as a film thickness (about 10 nm or more and 30 nm or less) of the current confinement layer 110 positioned at a node of the standing wave.

The optical loss causing layer 120 is inserted so as to be positioned at the node with respect to the standing wave in the required longitudinal mode. Since the node of the standing wave has a low intensity, an influence of a loss of the optical loss causing layer 120 on the required longitudinal mode is small. On the other hand, with respect to the standing wave in the unnecessary longitudinal mode, the optical loss causing layer 120 is positioned at an antinode other than the node. Since the antinode of the standing wave has a higher intensity than the node, the loss given to the unnecessary longitudinal mode by the optical loss causing layer 120 is large. In this manner, since a loss to the required longitudinal mode is reduced and a loss to the unnecessary longitudinal mode is increased, the unnecessary longitudinal mode is selectively prevented from resonating and hopping between longitudinal modes is prevented.

The optical loss causing layer 120 does not necessarily need to be provided at a position of each node of the standing wave in the required longitudinal mode of the resonator extension region 104, and may be a single layer. In this case, since an intensity of the standing wave increases as coming close to the active region 106, the optical loss causing layer 120 may be formed at a position of a node close to the active region 106. Further, when the switching or the popping between the longitudinal modes is allowed, the optical loss causing layer 120 may not be provided.

### (VCSEL-B of 3D Shape Measurement Light Source 20)

Next, the VCSEL-B of the 3D shape measurement light source 20 will be described.

The 3D shape measurement light source 20 emits light in order to specify the 3D shape of the object to be measured. Therefore, the 3D shape measurement light source 20 irradiates a predetermined measurement range with a predetermined light density. Here, it is preferable that the VCSEL-B of the 3D shape measurement light source 20 is configured by a multi-mode VCSEL that is more likely to have a higher output than the single-mode VCSEL.

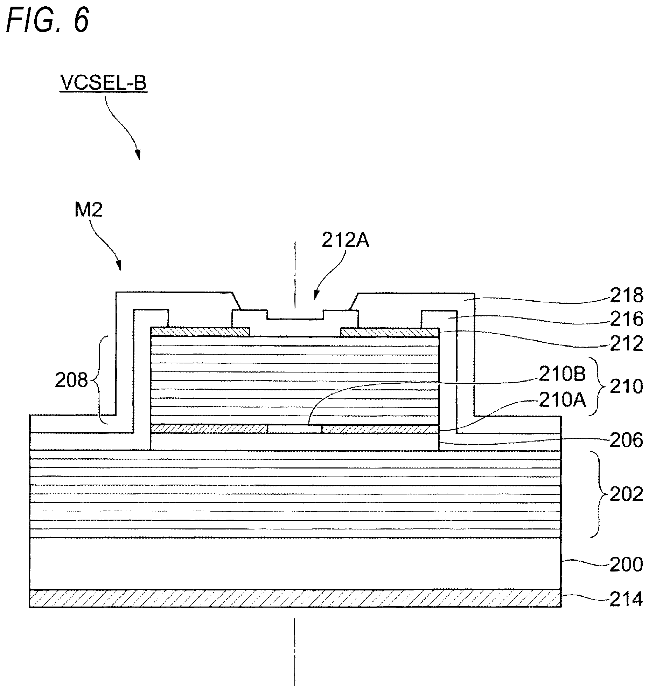

Fig. 6 is a diagram illustrating a cross-sectional structure of one VCSEL-B in the 3D shape measurement light source 20. The VCSEL-B is the VCSEL having the general λ resonator structure described above. That is, the VCSEL-B does not include the resonator extension region 104 in the VCSEL-A described above.

The VCSEL-B is formed by stacking, on an n-type GaAs substrate 200, an n-type lower DBR 202 in which AlGaAs layers having different Al compositions are alternately stacked, an active region 206 that is formed on the lower DBR 202 and includes a quantum well layer interposed between an upper spacer layer and a lower spacer layer, and a p-type upper DBR 208 that is formed on the active region 206 and in which AlGaAs layers having different Al compositions are alternately stacked. A current confinement layer 210 of p-type AlAs is formed on a lowermost layer of the upper DBR 208 or inside thereof.

Since the lower DBR 202, the active region 206, the upper DBR 208, and the current confinement layer 210 are the same as the lower DBR 102, the active region 106, the upper DBR 108, and the current confinement layer 110 of the VCSEL-A described above, descriptions thereof will be omitted.

By etching semiconductor layers stacked from the upper DBR 208 to the lower DBR 202, a columnar mesa M2 is formed on the substrate 200, and the current confinement layer 210 is exposed to a side surface of the mesa M2. In the current confinement layer 210, an oxidized region 210A selectively oxidized from the side surface of the mesa M2 and a conductive region 210B surrounded by the oxidized region 210A are formed. The conductive region 210B is an oxidized aperture. A planar shape of the conductive region 210B parallel to a substrate is a shape that reflects an outer shape of the mesa M2, that is, a circular shape, and a center of the shape substantially coincides with a central axis direction of the mesa M2 indicated by a dashed-dotted line.

An annular p-side electrode 212 made of metal in which Ti/Au or the like is stacked is formed on an uppermost layer of the mesa M2, and the p-side electrode 212 is in ohmic contact with a contact layer of the upper DBR 208. A circular light emission port 212A whose center coincides with an axis direction of the mesa M2 is formed in the p-side electrode 212, and a laser beam is emitted to the outside from the light emission port 212A. That is, the axis direction of the mesa M2 is an optical axis. Further, a cathode electrode 214 is formed as an n-side electrode on a back surface of the substrate 200. A front surface of the upper DBR 208 including the light emission port 212A is an emission surface.

An insulating layer 216 is provided so as to cover a front surface of the mesa M2 except for a portion where the p-side electrode 212 and an anode electrode 218 to be described later are connected and the light emission port 212A. The anode electrode 218 is provided so as to be in ohmic contact with the p-side electrode 212 except for the light emission port 212A. The anode electrode 218 is provided at a position except for a position of the light emission port 212A of each of the plural VCSELs-B. That is, in the plural VCSELs-B constituting the 3D shape measurement light source 20, the respective p-side electrodes 212 are connected in parallel by the anode electrode 218.

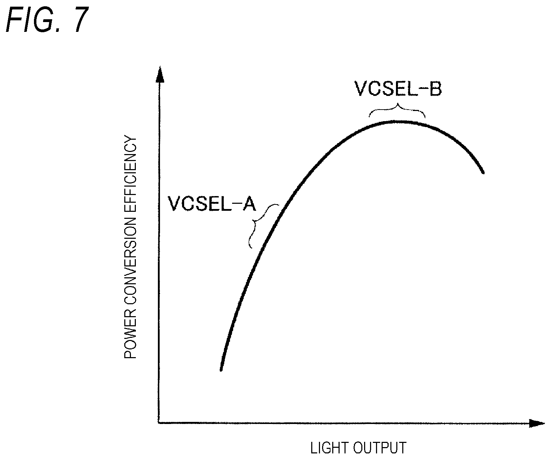

Fig. 7 is a diagram illustrating a relationship between a light output and a power conversion efficiency of a general VCSEL.

Generally, the VCSELs have a maximum power conversion efficiency when the light output of one VCSEL is 4 mW or more and 8 mW or less. However, compared to the case where the light output is used in a range smaller than the above range, the spread angle is increased. Therefore, an increase in the light density on the irradiation surface is not proportional to an increase in the light output.

Here, the VCSEL-A of the proximity detection light source 10 is preferably driven so as to have a light output range in which the power conversion efficiency decreases. That is, by intentionally causing the VCSEL-A to emit light at a light output lower than that in the range in which the power conversion efficiency is maximized, the VCSEL-A is made to emit light at a small spread angle. When a light density is insufficient on an irradiation surface, a light output per VCSEL-A is not increased, the light density may be increased while maintaining a small spread angle by increasing the number of VCSELs-A. The light output of one of the VCSELs-A is set to, for example, 1 mW or more and 4 mW or less. The number of the VCSELs-A in the proximity detection light source 10 is, for example, 1 or more and 50 or less. In the configuration illustrated in Fig. 4, as described above, in order to increase the light density while avoiding the range (4 mW or more and 8 mW or less) in which the power conversion efficiency is maximized, the proximity detection light source 10 is configured to include the plural VCSELs-A.

On the other hand, the VCSEL-B of the 3D shape measurement light source 20 may be driven so as to have a light output range in which the power conversion efficiency is maximized. The light output of one of the VCSELs-B is set to, for example, 4 mW or more and 8 mW or less. The number of the VCSELs-B in the 3D shape measurement light source 20 is, for example, 100 or more and 1000 or less.

### (Configuration of Diffusion Plate 30)

Next, the diffusion plate 30 will be described.

Fig. 8 is a diagram illustrating an example of a configuration of the diffusion plate 30. In Fig. 8, (a) is a plan view, and (b) is a cross-sectional view taken along a line VIIIB-VIIIB in (a).

As illustrated in (a) and (b) of Fig. 3, the diffusion plate 30 is provided on the side to which the proximity detection light source 10 and the 3D shape measurement light source 20 emit light, and diffuses the light emitted from the proximity detection light source 10 and the 3D shape measurement light source 20, respectively. The diffusion plate 30 has a function of further expanding the spread angle of the light incident on the diffusion plate 30.

As illustrated in (a) of Fig. 8, the diffusion plate 30 includes a first region 30A and a second region 30B. In other words, the diffusion plate 30 is configured as a member in which the first region 30A and the second region 30B are integrated. The first region 30A is provided on the emission path of the light from the VCSEL-A of the proximity detection light source 10, and the second region 30B is provided on the emission path of the light from the 3D shape measurement light source 20. That is, as illustrated in (a) of Fig. 3, when the light-emitting device 4 is viewed from the front surface (in a plan view), the first region 30A of the diffusion plate 30 is provided to face the position where the proximity detection light source 10 is disposed, and the second region 30B of the diffusion plate 30 is provided to face the 3D shape measurement light source 20. When the proximity detection light source 10 and the 3D shape measurement light source 20 are covered with a common diffusion plate 30, when light from the proximity detection light source 10 is also diffused by the diffusion plate 30, proximity detection becomes difficult. Therefore, in order to use the common diffusion plate 30, as described above, the diffusion plate 30 includes the first region 30A and the second region 30B. In the present exemplary embodiment, the proximity detection light source 10 and the 3D shape measurement light source 20 are disposed close to each other. This is because when the distance between the proximity detection light source 10 and the 3D shape measurement light source 20 are separated far from each other with a distance, a diffusion plate larger than necessary is required when the common (integrated) diffusion plate 30 is adopted. As described above, in the present exemplary embodiment, a small diffusion plate 30 in which the first region 30A and the second region 30B are integrated is adopted.

A diffusion angle at the second region 30B of the diffusion plate 30 is set to be larger than that of the first region 30A. For example, as illustrated in (b) of Fig. 8, the diffusion plate 30 includes a resin layer 32 in which unevenness for diffusing light is formed on one surface of a flat glass base material 31 whose both sides are parallel to each other. The first region 30A and the second region 30B are different in shapes of the unevenness, and the diffusion angle of the second region 30B is set to be larger. The diffusion angle means a spread angle of light passed through the diffusion plate 30.

Here, the first region 30A is not provided with unevenness, and is configured not to diffuse the light. For example, the resin layer 32 of the diffusion plate 30 is provided with unevenness in the second region 30B, but is configured to be flat without any unevenness in the first region 30A. Further, for example, in the first region 30A of the diffusion plate 30, a surface of the flat glass base material 31 whose both surfaces are parallel to each other is exposed. Here, the first region 30A does not need to be completely flat, and may have an uneven shape as long as the diffusion angle is smaller than that of the second region 30B. The first region 30A of the diffusion plate 30 may be a through hole through which the light passes. When the first region 30A of the diffusion plate 30 is the through hole, the light is not diffused as in the case where the first region 30A is flat. In this way, a member having a diffusion function, that is, a light diffusion member may be provided on the emission path of the 3D shape measurement light source 20.

As illustrated in (b) of Fig. 8, the VCSEL-A of the proximity detection light source 10 is disposed at a position facing the first region 30A of the diffusion plate 30. On the other hand, the VCSEL-B of the 3D shape measurement light source 20 is disposed at a position facing the second region 30B of the diffusion plate 30. A spread angle of emitted light of the VCSEL-A is set as θ1, and a spread angle of emitted light of the VCSEL-B is set as θ2. Note that θ1 is smaller than θ2 (that is, θ1 < θ2).

When the light emitted from the VCSEL-A passes through the first region 30A in which the unevenness is not provided, the light is not diffused, and is passed through the first region 30A in a state where the spread angle θ1 of the emitted light is maintained and is equal to a diffusion angle α.

On the other hand, when the light emitted from the VCSEL-B passes through the second region 30B provided with the unevenness, light is diffused, and light having a diffusion angle β larger than the spread angle θ2 of the emitted light is emitted from the diffusion plate 30.

The spread angles θ1 and θ2 and the diffusion angles α and β are full width at half maximum (FWHM).

As described above, the diffusion plate 30 is configured such that the diffusion angle at the first region 30A is smaller than the diffusion angle at the second region 30B. In this way, the light emitted from the VCSEL-B of the 3D shape measurement light source 20 is further diffused in the second region 30B and emitted to the outside. As a result, compared to a case where the emitted light from the VCSEL-B is emitted to the outside without being diffused in the second region 30B, an irradiation pattern having more uniformity is obtained on a wider irradiation surface. The second region 30B may be configured to have a uniform diffusion angle over the entire second region 30B, or may be configured such that diffusion angle differs according to positions in the second region 30B. Further, the second region 30B may be configured such that an optical axis of the VCSEL-B and a central axis of the light after the diffusion coincide with each other, or may be formed such that an irradiation area is increased by intentionally shifting the central axis of the light after the diffusion with respect to the optical axis of the VCSEL-B.

The first region 30A may include an optical element that narrows the spread angle θ1 of the emitted light of the VCSEL-A of the proximity detection light source 10. Such an optical element may be obtained by, for example, setting the first region 30A into a convex lens shape. Here, narrowing the spread angle includes not only a case where incident light is condensed, but also a case where incident light is set to be parallel light and is diffused, but a degree of diffusion is narrowed.

A size of the first region 30A may be determined in consideration of the number of the VCSELs-A of the proximity detection light source 10, a spread angle θ of the emitted light, an intensity of the emitted light, or the like. As an example, when the proximity detection light source 10 is used for face authentication, for example, when the number of the VCSELs-A is in a range of 1 or more and 50 or less, the first region 30A may have a lateral width and a longitudinal width in a range of 50 µm or more and 500 µm or less. Further, in (a) of Fig. 8, a front surface shape of the first region 30A in a plan view is circular, but may be a square, a rectangle, a polygon, or a combination thereof. Further, the lateral width and the longitudinal width of the first region 30A, that is, the size of the first region 30A may be set based on the light output emitted from the proximity detection light source 10. For example, the first region 30A may be set in a range larger than a region of the full width at half maximum of the light emitted from the proximity detection light source 10, and smaller than the region having an intensity of 0.1%. When the VCSEL-A and the VCSEL-B are desired to be closer to each other, the first region 30A may be set to a range smaller than the region having an intensity of 1% or a range smaller than the region having an intensity of 5%.

A size of the diffusion plate 30 including the first region 30A and the second region 30B may be set such that, for example, a lateral width and a longitudinal width are 1 mm or more and 10 mm or less, and a thickness is 0.1 mm or more and 1 mm or less. The diffusion plate 30 may cover the proximity detection light source 10, the 3D shape measurement light source 20, and the light amount monitoring light receiving element 40 in a plan view. In addition, an example in which the diffusion plate 30 has a quadrangular shape in a plan view is illustrated, but the diffusion plate 30 may have another shape such as a polygonal shape and a circular shape. When the diffusion plate 30 has the size and shape as described above, a light diffusion member suitable for face authentication of the portable information processing terminal and relatively short distance measurement up to about several meters is particularly provided.

### (Positional Relationship between Diffusion Plate 30, VCSEL-A of Proximity Detection Light Source 10, and VCSEL-B of 3D Shape Measurement Light Source 20)

A positional relationship between the VCSEL-A of the proximity detection light source 10 and the VCSEL-B of the 3D shape measurement light source 20 will be described with reference to (b) of Fig. 8. Here, it is assumed that a disposition interval between the VCSEL-A of the proximity detection light source 10 and the VCSEL-B of the 3D shape measurement light source 20 adjacent to each other is p1, an interval between the VCSELs-A of the proximity detection light source 10 is p2, and an interval between the VCSELs-B of the 3D shape measurement light source 20 is p3.

At this time, as can be seen from (b) of Fig. 8, when the VCSEL-B is too close to the proximity detection light source 10, that is, when the interval p1 is small, light having a large light intensity emitted from the VCSEL-B passes through the first region 30A of the diffusion plate 30, and is easily emitted to the outside in a state where the light is not diffused or diffusion is weak. For this reason, it is preferable to provide a distance between the VCSEL-A and the VCSEL-B that are adjacent to each other. For example, it is preferable that the VCSEL-B of the light source for 3D shape measurement 20 adjacent to the first region 30A of the diffusion plate 30 is disposed such that the range of the spread angle θ2 of the emitted light does not overlap the first region 30A of the diffusion plate 30. In this way, compared to the case where the range of the spread angle θ2 of the emitted light of the VCSEL-B of the 3D shape measurement light source 20 overlaps the first region 30A of the diffusion plate 30, the amount of light emitted from the VCSEL-B of the 3D shape measurement light source 20 and passing through the first region 30A of the diffusion plate 30 is reduced.

For example, it is preferable that the disposition interval p1 of the VCSEL-A of the proximity detection light source 10 and the VCSEL-B of the 3D shape measurement light source 20 adjacent to each other is larger than the interval p3 between the VCSELs-B of the 3D shape measurement light source 20.

Further, the spread angle θ1 of the emitted light of the VCSEL-A of the proximity detection light source 10 is set to be smaller than the spread angle θ2 of the emitted light of the VCSEL-B of the 3D shape measurement light source 20. However, when a distance from the light emission port 112A (see Fig. 5) of the VCSEL-A of the proximity detection light source 10 to the diffusion plate 30 is referred to as a distance g1, and a distance from the light emission port 212A of the VCSEL-B of the 3D shape measurement light source 20 to the diffusion plate 30 is referred to a distance g2, the distance g1 is smaller than the distance g2 (that is, g1 < g2), as shown in (b) of Fig. 8, even when the first region 30A of the diffusion plate 30 is small, it is easy for the emitted light from the VCSEL-A of the proximity detection light source 10 to pass through the first region 30A and to be emitted to the object to be measured. That is, the light emission port 112A of the VCSEL-A of the proximity detection light source 10 may be disposed closer to the diffusion plate 30 than the light emission port 212A of the VCSEL-B of the 3D shape measurement light source 20.

In this way, it easy to reduce an area of the first region 30A of the diffusion plate 30. As the area of the first region 30A is smaller, the amount of light emitted from the VCSEL-B of the 3D shape measurement light source 20 and passing through the first region 30A is further reduced, so that the VCSEL-B of the 3D shape measurement light source 20 may be disposed closer to the proximity detection light source 10. That is, a region (dead space) in which the VCSEL-B cannot be disposed and that is generated between the VCSEL-A of the proximity detection light sources 10 and the VCSEL-B of the 3D shape measurement light source 20 adjacent to each other is reduced, and the size of the diffusion plate 30 or the spacer 33 is reduced.

Since the VCSEL-B of the 3D shape measurement light source 20 has a larger light output than the VCSEL-A of the proximity detection light source 10, the temperature is likely to rise. Therefore, when the interval p3 between the VCSELs-B of the 3D shape measurement light source 20 is wider than the interval p2 between the VCSELs-A of the proximity detection light source 10 (that is, p3 > p2), the temperature rise is suppressed. On the other hand, since the VCSEL-A of the proximity detection light source 10 has a smaller light output than the VCSEL-B of the 3D shape measurement light source 20, the temperature is less likely to rise. Therefore, when the interval p2 that is the distance between the VCSELs-A of the proximity detection light source 10 is made smaller than the interval p3 that is the distance between the VCSELs-B of the 3D shape measurement light source 20, it is easy to reduce the occupied area of the proximity detection light source 10.

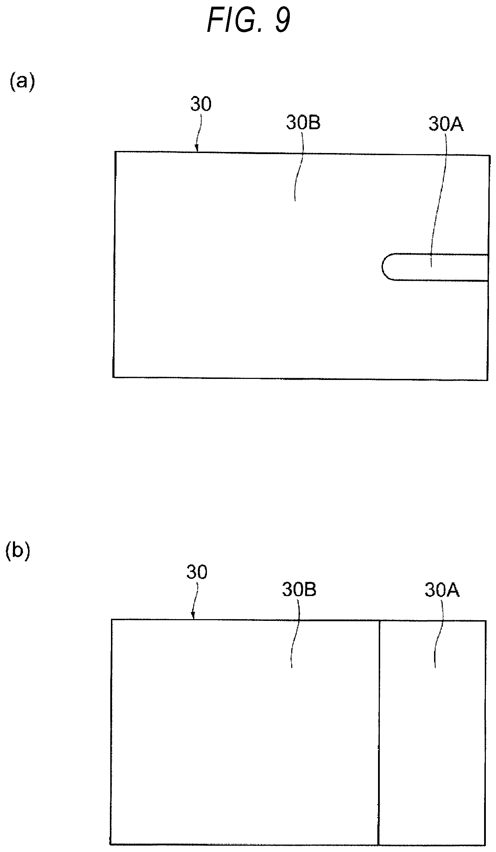

Further, as shown in (a) of Fig. 8, the first region 30A of the diffusion plate 30 is preferably set to a state of being surrounded by the second region 30B from four directions. In this way, compared to (a) and (b) of Fig. 9 to be described later, light emitted from the VCSEL-B of the 3D shape measurement light source 20 is suppressed from passing through the first region of the diffusion plate 30.

Next, modifications of the diffusion plate 30 will be described.

Fig. 9 is a diagram illustrating the modifications of the diffusion plate 30. In Fig. 9, (a) illustrates a first modification of the diffusion plate 30, and (b) illustrates a second modification of the diffusion plate 30.

In the first modification of the diffusion plate 30 shown in (a) of Fig. 9, a planar shape of the first region 30A of the diffusion plate 30 is a slit shape extending in the +x direction. In this way, a margin with respect to the disposition in ±x directions is widened. Even in this case, since the first region is surrounded by the second region, light emitted from the VCSEL-B of the 3D shape measurement light source 20 is suppressed from passing through the first region of the diffusion plate 30.

On the other hand, in the second modification of the diffusion plate 30 shown in (b) of Fig. 9, the first region 30A of the diffusion plate 30 is provided at a right end portion (+x direction side) of the diffusion plate 30. In the second modification, the first region is not surrounded by the second region. Therefore, in the second modification of the diffusion plate 30, the amount of light passing through the first region 30A of the diffusion plate 30 among the light emitted from the VCSEL-B of the 3D shape measurement light source 20 increases as compared with the first modification of the diffusion plate 30. However, in the configuration on an assumption that the light emitted from the VCSEL-B of the 3D shape measurement light source 20 is allowed to pass through the first region 30A, such as a case where the light output of the VCSEL-B of the 3D shape measurement light source 20 is small or a case where the distance between the VCSEL-B of the 3D shape measurement light source 20 and the first region 30A is long in a plan view, the second modification of the diffusion plate 30 may be adopted. In such a case, light emitted from the VCSEL-B of the 3D shape measurement light source 20 is suppressed from passing through the first region of the diffusion plate 30.

Here, the first region being surrounded by the second region means a state in which the second region 30B is present at least in two or more directions in a plan view.

### (Configuration of 3D Sensor 6)

Fig. 10 is a diagram illustrating the 3D sensor 6.

The 3D sensor 6 is configured by arranging the plural light receiving regions 61 in a matrix (lattice) shape. The 3D sensor 6 receives a light receiving pulse that is reflected light from the object to be measured with respect to an emitted light pulse from the light-emitting device 4, and stores, in each light receiving region 61, electric charge corresponding to a time until the light receiving pulse is received. The 3D sensor 6 is configured as, for example, a device having a CMOS structure in which each light receiving region 61 includes two gates and electric charge storage units corresponding thereto. The 3D sensor 6 is configured to transfer photoelectrons generated by alternately applying pulses to the two gates to one of the two electric charge storage units at a high speed, and store electric charges corresponding to a phase difference between the emitted light pulse and the light receiving pulse. Then, a digital value corresponding to the electric charges corresponding to the phase difference between the emitted light pulse and the light receiving pulse for each light receiving region 61 is outputted as a signal via an AD converter. That is, the 3D sensor 6 outputs a signal corresponding to a time from when light is emitted from the proximity detection light source 10 to when the light is received by the 3D sensor 6, and a signal corresponding to a time from when light is emitted from the 3D shape measurement light source 20 to when the light is received by the 3D sensor 6.

### (Flowchart of Authentication Processing in Information Processing Device 1)

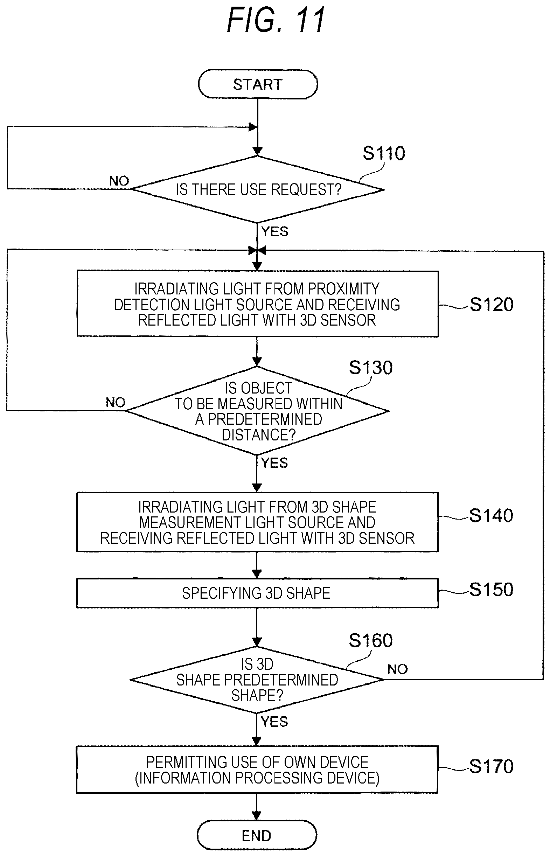

Fig. 11 is a flowchart for performing authentication processing related to use of the information processing device 1.

Here, it is assumed that the information processing device 1 includes at least an off state in which the power source is turned off, a standby state in which power source is supplied to only a part of the information processing device 1, and an operation state in which the power source is supplied to more parts than in the standby state, for example, the entire information processing device 1.

First, it is determined whether or not there is a use request of the information processing device 1 (step 110, the step is referred to as S110 in Fig. 11, and the same applies to the below). A case where there is a use request means a case where the power source is turned on in the off state, and a case where an operation is performed by a user in order to use the information processing device 1 in the standby state, or the like. This is an example of a case where there is a use request also in a case where a telephone, a mail, or the like is received in a standby state, that is, a case where the system control unit 9 receives a signal for shifting to an operation state.

When it is determined to be negative (NO) in step 110, that is, when the off state or the standby state of the information processing device 1 continues, step 110 is to be repeated.

On the other hand, when the determination is positive (YES) in step 110, that is, when the information processing device 1 shifts to the operation state, the proximity detection light source 10 irradiates the object to be measured with light, and the 3D sensor 6 receives reflected light from the object to be measured (step 120). Note that, regardless of the presence or absence of the use request in step 110, the proximity detection light source 10 may continue emitting light in the standby state of the information processing device 1.

Next, it is determined whether or not the object to be measured is close (step 130). The fact that the close of the object to be measured are close to each other means that there is an object to be measured within a predetermined distance. When it is determined to be negative (NO) in step 130, that is, when the object to be measured is not close, the process returns to step 120.

On the other hand, when it is determined to be positive (YES) in step 130, that is, when the object to be measured is close, the 3D shape measurement light source 20 emits light, and the reflected light from the object to be measured is received by the 3D sensor 6 (step 140). At this time, the irradiation of the light from the proximity detection light source 10 may be stopped or continued. When the irradiation from the proximity detection light source 10 is continued, an irradiation pattern on the irradiation surface tends to be more uniform compared to the case where the irradiation is not continued.

Based on the light amount received by the 3D sensor 6, the shape specifying unit 81 of the optical device control unit 8 specifies the 3D shape of the object to be measured (step 150).

Next, it is determined whether or not the 3D shape that is a specification result specified by the authentication processing unit 91 is a predetermined shape (step 160). In step 160, when it is determined to be positive (YES), that is, when the specified 3D shape is a predetermined shape, the use of the own device (information processing device 1) is permitted (step 170). On the other hand, when it is determined to be negative (NO) in step 160, that is, when the specified 3D shape does not coincide with the shape stored in advance in the ROM or the like, the use of the information processing device 1 that is the own device is not permitted, and the process returns to step 120. In addition to the 3D shape, other information such as a two-dimensional image acquired by the 2D camera 93 may be added to determine whether or not to permit the use of the information processing device 1 that is the own device.

As described above, the information processing device 1 according to the present exemplary embodiment includes the proximity detection light source 10 and the 3D shape measurement light source 20. By the irradiation of the light from the proximity detection light source 10, it is determined whether or not the object to be measured is close to the information processing device 1, and when the object to be measured is close to the object to be measured, the 3D measurement light is irradiated from the 3D shape measurement light source 20. That is, it is possible to prevent the 3D shape measurement light source 20 from emitting light even though the object to be measured is not close. In addition, at this time, by making the light output of the proximity detection light source 10 smaller than the light output of the 3D shape measurement light source 20, power consumption is suppressed. When the information processing device 1 is the portable information processing terminal, a decrease in a charge amount of a battery is prevented.

### (Connection Relationship Between Proximity Detection Light Source 10 and 3D Shape Measurement Light Source 20 with Circuit Board 7)

Next, the connection relationship between the proximity detection light source 10 and the 3D shape measurement light source 20 with conductor patterns provided on the circuit board 7 will be described with reference to Fig. 4.

On the circuit board 7, a cathode pattern 71 and an anode pattern 72 for the proximity detection light source 10, a cathode pattern 73 and anode patterns 74A, 74B for the 3D shape measurement light source 20 are provided as conductor patterns.

As described above, in the proximity detection light source 10, the cathode electrode 114 is provided on the back surface, and the anode electrode 118 is provided on the surface (see Fig. 5). The anode electrode 118 includes a pad unit 118A to which p-side electrodes 112 of four VCSELs-A are connected, and to which a bonding wire 76 to be described later is connected.

Similarly, in the 3D shape measurement light source 20, a cathode electrode 214 is provided on the back surface, and an anode electrode 218 is provided on the front surface (see Fig. 6). The anode electrode 218 includes pad units 218A, 218B extending in ±y direction sides while being formed to connect the anode electrodes 218 of the VCSELs-B disposed in a matrix, and to which bonding wires 75A, 75B to be described later are connected.

The cathode pattern 71 for the proximity detection light source 10 is formed to have an area larger than that of the proximity detection light source 10 such that the cathode electrode 114 provided on the back surface of the proximity detection light source 10 is connected. In the proximity detection light source 10, the cathode electrode 114 provided on the back surface and the cathode pattern 71 for the proximity detection light source 10 on the circuit board 7 are adhered by a conductive adhesive. The pad unit 118A of the anode electrode 118 of the proximity detection light source 10 is connected to the anode pattern 72 on the circuit board 7 by the bonding wire 76.

Similarly, the cathode pattern 73 for the 3D shape measurement light source 20 is formed to have an area larger than that of the 3D shape measurement light source 20 such that the cathode electrode 214 provided on the back surface of the 3D shape measurement light source 20 is connected. The 3D shape measurement light source 20 is adhered to the cathode pattern 73 for the 3D shape measurement light source 20 by a conductive adhesive or the like.

The anode patterns 74A, 74B for the 3D shape measurement light source 20 are provided so as to face two sides (±y direction sides) of the anode electrode 218 (see Fig. 6) provided on the surface of the 3D shape measurement light source 20. The anode patterns 74A, 74B and the pad units 218A, 218B of the anode electrode 218 of the 3D shape measurement light source 20 are connected by bonding wires 75A, 75B, respectively. Although plural bonding wires 75A, 75B are provided, one of the bonding wires 75A is denoted by a reference numeral and one of the bonding wires 75B is denoted by a reference numeral.

### (Drive Method)

When it is desired to drive the proximity detection light source 10 and the 3D shape measurement light source 20 at a higher speed, both the proximity detection light source 10 and the 3D shape measurement light source 20 may be driven on the low side. The low side driving means a configuration in which a drive unit such as a MOS transistor is positioned downstream in a current path with respect to a drive target such as a VCSEL. Conversely, a configuration in which a drive unit is positioned upstream is referred to as high side driving. In the present exemplary embodiment, in order to drive both the proximity detection light source 10 and the 3D shape measurement light source 20 on the low side, the cathodes of both the light source 10 and the 3D shape measurement light source 20 are separated and independently driven.

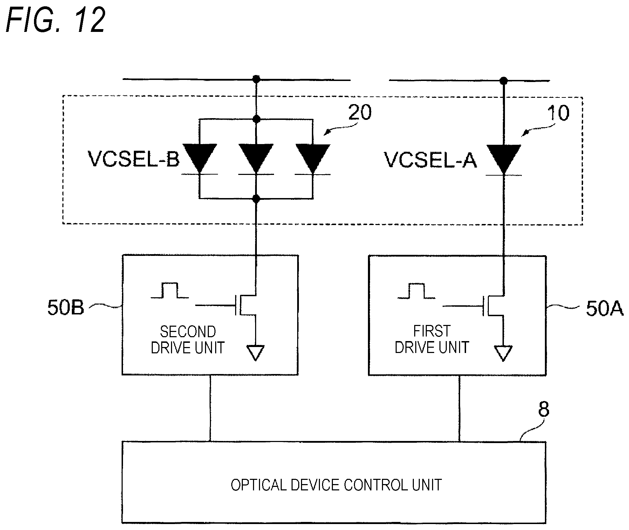

Fig. 12 is a diagram illustrating the low side driving. Fig. 12 illustrates the relationship between the VCSEL-A of the proximity detection light source 10, the VCSEL-B of the 3D shape measurement light source 20, the first drive unit 50A, the second drive unit 50B, and the optical device control unit 8. The first drive unit 50A and the second drive unit 50B are grounded via MOS transistors. That is, by turning on or off the MOS transistor, low side driving of the VCSEL is performed.

In Fig. 12, the VCSEL-A of the proximity detection light source 10 and the VCSEL-B of the 3D shape measurement light source 20 are also separated from each other on an anode side.

### (Disposition of Proximity Detection Light Source 10, 3D Shape Measurement Light Source 20, and Light Quantity Monitoring Light-receiving Element 40 in Light Emitting Device 4)

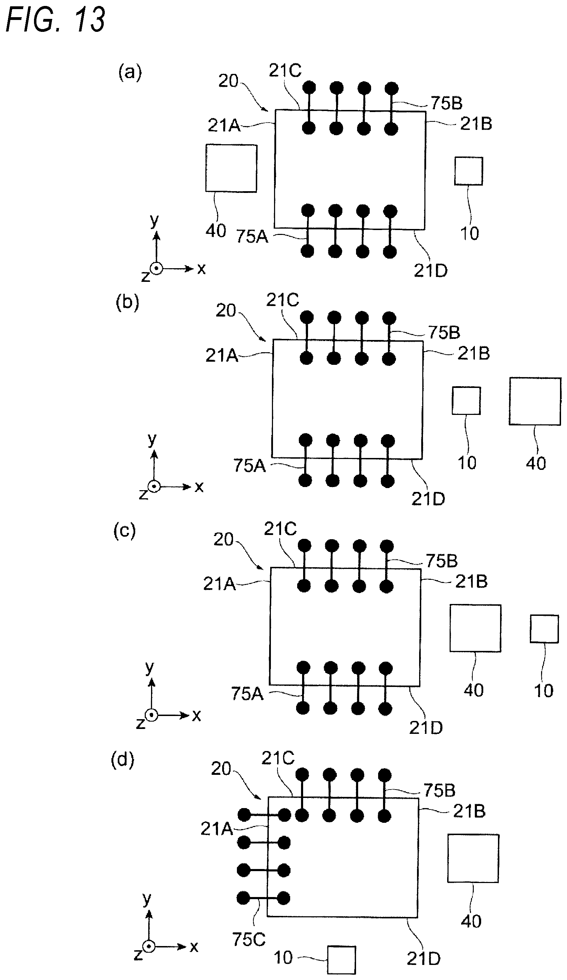

Fig. 13 is a diagram illustrating the disposition of the proximity detection light source 10, the 3D shape measurement light source 20, and the light amount monitoring light receiving element 40 in the light-emitting device 4. In Fig. 13, (a) illustrates a disposition described as the present exemplary embodiment, (b) illustrates a first modification of the disposition, (c) illustrates a second modification of the disposition, and (d) illustrates a third modification of the disposition. Here, the proximity detection light source 10, the 3D shape measurement light source 20, the light amount monitoring light receiving element 40, and the bonding wire are illustrated, and other description is omitted. A side surface in the -x direction of the 3D shape measurement light source 20 having a quadrangular planar shape is referred to as a side surface 21A, a side surface in the +x direction is referred to as a side surface 21B, a side surface in the +y direction is referred to as a side surface 21C, and a side surface in the -y direction is referred to as a side surface 21D. Here, the side surface 21A and the side surface 21B face each other, and the side surface 21C and the side surface 21D face each other by connecting the side surface 21A and the side surface 21B.

In the disposition described as the present exemplary embodiment illustrated in (a) of Fig. 13 (see (a) of Fig. 3), the light amount monitoring light receiving element 40 is provided on the side surface 21A side in the -x direction of the 3D shape measurement light source 20. The proximity detection light source 10 is provided on the +x direction side surface 21B side of the 3D shape measurement light source 20. The bonding wires 75A, 75B connecting the anode electrode 218 (see Fig. 6) of the 3D shape measurement light source 20 and the anode patterns 74A, 74B (see Fig. 4) provided on the circuit board 7 are provided so as to face the side surfaces 21C, 21D of the 3D shape measurement light source 20 in the ±y direction.

According to such a disposition of the present exemplary embodiment, a current is supplied to each VCSEL-B of the 3D shape measurement light source 20 symmetrically from the ±y direction of the 3D shape measurement light source 20. Therefore, compared to the third comparative example of the disposition illustrated in (d) of Fig. 13 to be described later, current is likely to be more uniformly supplied to each VCSEL-B of the 3D shape measurement light source 20.

Since no bonding wire is provided on the side surface 21A side in the -x direction of the 3D shape measurement light source 20 on which the light amount monitoring light receiving element 40 is disposed, the light amount monitoring light receiving element 40 is easily disposed close to the 3D shape measurement light source 20. Therefore, in the disposition of the present exemplary embodiment, the light amount monitoring light receiving element 40 easily receives the light reflected by the diffusion plate 30 among the light emitted from the 3D shape measurement light source 20, as compared with the second comparative example of the arrangement illustrated in (c) of Fig. 13 to be described later.

In the first modification of the disposition illustrated in (b) of Fig. 13, the light amount monitoring light receiving element 40 is disposed on the +x direction side surface 21B side of the 3D shape measurement light source 20 and outside the proximity detection light source 10. That is, compared to the disposition in the present exemplary embodiment illustrated in (a) of Fig. 13, the distance between the 3D shape measurement light source 20 and the light amount monitoring light receiving element 40 is long. Therefore, the light receiving amount of light reflected by the diffusion plate 30 of the light emitted from the 3D shape measurement light source 20 is reduced, and the light reflected by the diffusion plate 30 is less likely to be received. Therefore, a detection accuracy may decrease.

In the second modification of the disposition illustrated in (c) of Fig. 13, the light amount monitoring light receiving element 40 is disposed on the +x direction side surface 21B side of the 3D shape measurement light source 20 and between the 3D shape measurement light source 20 and the proximity detection light source 10. Therefore, it is easy to dispose the light amount monitoring light receiving element 40 close to the 3D shape measurement light source 20. Therefore, similarly to the disposition in the exemplary embodiment illustrated in (a) of Fig. 13 described above, in the second modification of the disposition, the current is easily supplied to each of the VCSELs-B of the 3D shape measurement light source 20 more uniformly, and the light amount monitoring light receiving element 40 easily receives the light reflected by the diffusion plate 30 among the emitted light from the 3D shape measurement light source 20.

In the third modification of the disposition illustrated in (d) of Fig. 13, the bonding wire 75A provided in the present exemplary embodiment illustrated in (a) of Fig. 13 is not provided. Instead, the anode pattern is separately provided on the circuit board 7 on the side surface 21A side in the -x direction of the 3D shape measurement light source 20, and the bonding wire 75C for connecting the anode electrode 218 of the 3D shape measurement light source 20 and the anode pattern separately provided on the circuit board 7 is provided. Although plural bonding wires 75C are provided, one of the bonding wires 75C is denoted by a reference numeral.

In the third modification of the arrangement illustrated in (d) of Fig. 13, the proximity detection light source 10 is provided on the side surface 21D side in the -y direction of the 3D shape measurement light source 20, and the light amount monitoring light receiving element 40 is provided on the +x direction side surface 21B side of the 3D shape measurement light source 20. In this way, the 3D shape measurement light source 20 and the light amount monitoring light receiving element 40 are disposed close to each other. However, since a current is supplied from two sides of the side surface 21C side in the +y direction and the side surface 21A side in the -x direction to the VCSELs-B of the 3D shape measurement light source 20, it is difficult for the current to flow uniformly to each VCSEL-B of the 3D shape measurement light source 20. Therefore, the third modification is preferably used in a specification with a little influence even when it is difficult for a current to flow uniformly.

In the configuration described above, the light-emitting device 4 and the 3D sensor 6 are disposed on a common circuit board 7, but may be disposed on different circuit boards. In the light-emitting device 4, at least the proximity detection light source 10, the 3D shape measurement light source 20, the diffusion plate 30, and the spacer 33 may be provided on a substrate different from the circuit board 7, and these may be configured as one light-emitting component (module) so as to be connectable to the circuit board 7 on which the first drive unit 50A, the second drive unit 50B, the 3D sensor 6, and the like are mounted. As an example, the maximum outer shape of the light-emitting component may be defined by the diffusion plate 30 covering the proximity detection light source 10 and the 3D shape measurement light source 20, the spacer 33, and the substrate. With such a configuration, since the first drive unit 50A, the second drive unit 50B, the 3D sensor 6, and the like are not mounted on the light-emitting component, the light-emitting component is provided and distributed as a small component. In addition, since the proximity detection light source 10 and the 3D shape measurement light source 20 are sealed by being surrounded by the diffusion plate 30, the spacer 33, and the substrate, compared to the case where the proximity detection light source 10 and the 3D shape measurement light source 20 are not sealed, dust-proof, moisture-proof, and the like may be realized. The light-emitting component may include or may not include the light amount monitoring light receiving element 40.

The proximity detection light source 10 in the above configuration is not necessarily used in combination with the 3D shape measurement light source 20. For example, the proximity detection light source 10 may be provided alone as a distance measurement light source, regardless of whether or not the 3D shape is measured. That is, the proximity detection light source may be provided as a single vertical cavity surface emitting laser element array having plural long cavity structures connected in parallel to each other. In such a configuration, when the light source is driven in a range lower than where the power conversion efficiency is maximized (for example, 4 mW or more and 8 mW or less), it is possible to increase the light density while suppressing an increase in the spread angle compared to a case where the light source is driven within the range where the power conversion efficiency by only one surface emitting laser element is maximized. In such a case, particularly in a configuration in which a visual field range of a light receiving unit is narrow and light is emitted in a range wider than the visual field range of the light receiving unit on an irradiation surface, light may be received in a higher SN ratio.

The proximity detection light source 10 configured as described above may be applied not only to a distance measurement light source, but also to a light source for other applications in which the light density is desired to be increased while suppressing an increase in spread angle.

## Claims

1. A light-emitting device (4), comprising:
a first light source (10) that oscillates in a single lateral mode;
a second light source (20) that oscillates in a multiple lateral mode, the second light source (20) having a light output larger than a light output of the first light source (10) and being configured to be driven independently from the first light source (10); and
a light diffusion member (30) that is provided on an emission path of the second light source (20).

2. The light-emitting device (4) according to claim 1, wherein
the first light source (10) includes at least one first vertical cavity surface emitting laser element (VCSEL-A), and the second light source (20) includes a plurality of second vertical cavity surface emitting laser elements (VCSEL-B), and
the light-emitting device (4) is driven such that a light output emitted from one of the first vertical cavity surface emitting laser element (VCSEL-A) is smaller than a light output emitted from one of the second vertical cavity surface emitting laser element (VCSEL-B).

3. The light-emitting device (4) according to claim 1, wherein
the first light source (10) includes at least one first vertical cavity surface emitting laser element (VCSEL-A), the second light source (20) includes a plurality of second vertical cavity surface emitting laser elements (VCSEL-B), and
the light-emitting device (4) is driven with a light output such that a power conversion efficiency of the first vertical cavity surface emitting laser element (VCSEL-A) is lower than a power conversion efficiency of the second vertical cavity surface emitting laser element (VCSEL-B).

4. The light-emitting device (4) according to claim 2 or 3, wherein
the first vertical cavity surface emitting laser element (VCSEL-A) is driven such that a light output of one of the first vertical cavity surface emitting laser element (VCSEL-A) is in a range of 1 mW or more and 4 mW or less.

5. The light-emitting device (4) according to any one of claims 2 to 4, wherein
the second vertical cavity surface emitting laser element (VCSEL-B) is driven such that a light output of one of the second vertical cavity surface emitting laser element (VCSEL-B) is in a range of 4 mW or more and 8 mW or less.

6. The light-emitting device (4) according to any one of claims 2 to 5, wherein
the first vertical cavity surface emitting laser element (VCSEL-A) has a long cavity structure having a cavity length of 5λ or more and 20λ or less when an oscillation wavelength is λ.

7. An optical device (3), comprising:
the light-emitting device (4) according to any one of claims 1 to 6; and
a light receiving unit (40) that receives a first reflected light emitted from the first light source (10) of the light-emitting device (4) and reflected by an object to be measured and a second reflected light emitted from the second light source (20) of the light-emitting device (4) and reflected by the object to be measured,
wherein the light receiving unit (40) outputs a signal corresponding to a time from when light is emitted from the first light source (10) to when the light from the first light source (10) is received by the light receiving unit (40), and a signal corresponding to a time from when light is emitted from the second light source (20) to when the light from the second light source (20) is received by the light receiving unit (40).

8. An optical device (3), comprising:
the light-emitting device (4) according to any one of claims 1 to 6; and
a light receiving unit (40) that receives a first reflected light emitted from the first light source (10) of the light-emitting device (4) and reflected by an object to be measured and a second reflected light emitted from the second light source (20) of the light-emitting device (4) and reflected by the object to be measured,
wherein light is emitted from the second light source (20) in a case where the first reflected light indicates that the object to be measured is present within a predetermined distance.

9. An information processing device (1), comprising:
the optical device (3) according to claim 7 or 8, and
a shape specifying unit (81) that specifies a three-dimensional shape of the object to be measured based on a second reflected light emitted from the second light source (20) of the optical device (3) and reflected by the object to be measured.

10. The information processing device (1) according to claim 9, further comprising
an authentication processing unit (91) that performs authentication processing related to use of the information processing device (1) based on a specification result by the shape specifying unit (81).

## Patentansprüche

1. Lichtemittierende Vorrichtung (4), umfassend:
eine erste Lichtquelle (10), die in einem einzigen lateralen Modus oszilliert;
eine zweite Lichtquelle (20), die in einem mehrfachen lateralen Modus oszilliert, wobei die zweite Lichtquelle (20) eine Lichtausgabe, die größer als eine Lichtausgabe der ersten Lichtquelle (10) ist, aufweist und so konfiguriert ist, dass sie unabhängig von der ersten Lichtquelle (10) angetrieben wird; und
ein Lichtdiffusionselement (30), das auf einem Emissionsweg der zweiten Lichtquelle (20) vorgesehen ist.

2. Lichtemittierende Vorrichtung (4) nach Anspruch 1, wobei
die erste Lichtquelle (10) mindestens ein erstes Oberflächenemissionslaser-Element mit vertikaler Kavität (VCSEL-A) enthält und die zweite Lichtquelle (20) mehrere zweite Oberflächenemissionslaser-Elemente mit vertikaler Kavität (VCSEL-B) enthält, und
die lichtemittierende Vorrichtung (4) so angetrieben wird, dass eine Lichtausgabe, die von einem der ersten Oberflächenemissionslaser-Elemente mit vertikaler Kavität (VCSEL-A) emittiert wird, kleiner als eine Lichtausgabe, die von einem der zweiten Oberflächenemissionslaser-Elemente mit vertikaler Kavität (VCSEL-B) emittiert wird, ist.

3. Lichtemittierende Vorrichtung (4) nach Anspruch 1, wobei
die erste Lichtquelle (10) mindestens ein erstes Oberflächenemissionslaser-Element mit vertikaler Kavität (VCSEL-A) enthält und die zweite Lichtquelle (20) mehrere zweite Oberflächenemissionslaser-Elemente mit vertikaler Kavität (VCSEL-B) enthält, und
die lichtemittierende Vorrichtung (4) mit einer Lichtausgabe so angetrieben wird, dass eine Leistungsumwandlungseffizienz des ersten Oberflächenemissionslaser-Elements mit vertikaler Kavität (VCSEL-A) niedriger als eine Leistungsumwandlungseffizienz des zweiten Oberflächenemissionslaser-Elements mit vertikaler Kavität (VCSEL-B) ist.

4. Lichtemittierende Vorrichtung (4) nach Anspruch 2 oder 3, wobei
das erste Oberflächenemissionslaser-Element mit vertikaler Kavität (VCSEL-A) so angetrieben wird, dass eine Lichtausgabe eines der ersten Oberflächenemissionslaser-Elemente mit vertikaler Kavität (VCSEL-A) in einem Bereich von 1 mW oder mehr und 4 mW oder weniger liegt.

5. Lichtemittierende Vorrichtung (4) nach einem der Ansprüche 2 bis 4, wobei
das zweite Oberflächenemissionslaser-Element mit vertikaler Kavität (VCSEL-B) so angetrieben wird, dass eine Lichtausgabe eines der zweiten Oberflächenemissionslaser-Elemente mit vertikaler Kavität (VCSEL-B) in einem Bereich von 4 mW oder mehr und 8 mW oder weniger liegt.

6. Lichtemittierende Vorrichtung (4) nach einem der Ansprüche 2 bis 5, wobei
das erste Oberflächenemissionslaser-Element mit vertikaler Kavität (VCSEL-A) eine lange Kavitätsstruktur mit einer Kavitätslänge von 5λ oder mehr und 20λ oder weniger aufweist, wenn eine Oszillationswellenlänge λ ist.

7. Optische Vorrichtung (3), umfassend:
die lichtemittierende Vorrichtung (4) nach einem der Ansprüche 1 bis 6; und
eine Lichtempfangseinheit (40), die ein erstes reflektiertes Licht, das von der ersten Lichtquelle (10) der lichtemittierenden Vorrichtung (4) emittiert wird und von einem zu messenden Objekt reflektiert wird, und ein zweites reflektiertes Licht, das von der zweiten Lichtquelle (20) der lichtemittierenden Vorrichtung (4) emittiert wird und von dem zu messenden Objekt reflektiert wird, empfängt,
wobei die Lichtempfangseinheit (40) ein Signal, das einer Zeit von Zeitpunkt, zu dem Licht von der ersten Lichtquelle (10) emittiert wird, bis Zeitpunkt, zu dem das Licht von der ersten Lichtquelle (10) von der Lichtempfangseinheit (40) empfangen wird, entspricht, und ein Signal, das einer Zeit von Zeitpunkt, zu dem Licht von der zweiten Lichtquelle (20) emittiert wird, bis Zeitpunkt, zu dem das Licht von der zweiten Lichtquelle (20) von der Lichtempfangseinheit (40) empfangen wird, entspricht, ausgibt.

8. Optische Vorrichtung (3), umfassend:
die lichtemittierende Vorrichtung (4) nach einem der Ansprüche 1 bis 6; und
eine Lichtempfangseinheit (40), die ein erstes reflektiertes Licht, das von der ersten Lichtquelle (10) der lichtemittierenden Vorrichtung (4) emittiert wird und von einem zu messenden Objekt reflektiert wird, und ein zweites reflektiertes Licht, das von der zweiten Lichtquelle (20) der lichtemittierenden Vorrichtung (4) emittiert wird und von dem zu messenden Objekt reflektiert wird, empfängt,
wobei Licht von der zweiten Lichtquelle (20) in einem Fall emittiert wird, in dem das erste reflektierte Licht angibt, dass das zu messende Objekt innerhalb einer vorbestimmten Distanz vorhanden ist.

9. Informationsverarbeitungsvorrichtung (1), umfassend:
die optische Vorrichtung (3) nach Anspruch 7 oder 8, und
eine Formspezifizierungseinheit (81), die eine dreidimensionale Form des zu messenden Objekts auf der Grundlage eines zweiten reflektierten Lichts, das von der zweiten Lichtquelle (20) der optischen Vorrichtung (3) emittiert wird und von dem zu messenden Objekt reflektiert wird, spezifiziert.

10. Informationsverarbeitungsvorrichtung (1) nach Anspruch 9, ferner umfassend:
eine Authentifizierungsverarbeitungseinheit (91), die Authentifizierungsverarbeitung in Bezug auf Verwendung der Informationsverarbeitungsvorrichtung (1) auf der Grundlage eines Spezifikationsergebnisses durch die Formspezifizierungseinheit (81) durchführt.

## Revendications

1. Dispositif d'émission de lumière (4), comprenant :
une première source de lumière (10) qui oscille dans un seul mode latéral ;
une deuxième source de lumière (20) qui oscille dans un mode latéral multiple, la deuxième source de lumière (20) ayant une sortie de lumière supérieure à une sortie de lumière de la première source de lumière (10) et étant configurée pour être pilotée indépendamment de la première source de lumière (10) ; et
un élément de diffusion de lumière (30) qui est prévu sur un chemin d'émission de la deuxième source de lumière (20).

2. Dispositif d'émission de lumière (4) selon la revendication 1, dans lequel
la première source de lumière (10) inclut au moins un premier élément laser à émission de surface à cavité verticale (VCSEL-A), et la deuxième source de lumière (20) inclut une pluralité de deuxièmes éléments laser à émission de surface à cavité verticale (VCSEL-B), et
le dispositif d'émission de lumière (4) est piloté de sorte qu'une sortie de lumière émise par l'un des premiers éléments laser à émission de surface à cavité verticale (VCSEL-A) est inférieure à une sortie de lumière émise par l'un des deuxièmes éléments laser à émission de surface à cavité verticale (VCSEL-B).

3. Dispositif d'émission de lumière (4) selon la revendication 1, dans lequel
la première source de lumière (10) inclut au moins un premier élément laser à émission de surface à cavité verticale (VCSEL-A), la deuxième source de lumière (20) inclut une pluralité de deuxièmes éléments laser à émission de surface à cavité verticale (VCSEL-B), et
le dispositif d'émission de lumière (4) est piloté avec une sortie de lumière telle qu'une efficacité de conversion de puissance du premier élément laser à émission de surface à cavité verticale (VCSEL-A) est inférieure à une efficacité de conversion de puissance du deuxième élément laser à émission de surface à cavité verticale (VCSEL-B).

4. Dispositif d'émission de lumière (4) selon la revendication 2 ou la revendication 3, dans lequel
le premier élément laser à émission de surface à cavité verticale (VCSEL-A) est piloté de sorte qu'une sortie de lumière de l'un des premiers éléments laser à émission de surface à cavité verticale (VCSEL-A) est comprise dans une plage de 1 mW ou plus et 4 mW ou moins.

5. Dispositif d'émission de lumière (4) selon l'une quelconque des revendications 2 à 4, dans lequel
le deuxième élément laser à émission de surface à cavité verticale (VCSEL-B) est piloté de sorte qu'une sortie de lumière de l'un des deuxièmes éléments laser à émission de surface à cavité verticale (VCSEL-B) est comprise dans une plage de 4 mW ou plus et 8 mW ou moins.

6. Dispositif d'émission de lumière (4) selon l'une quelconque des revendications 2 à 5, dans lequel
le premier élément laser à émission de surface à cavité verticale (VCSEL-A) a une structure de cavité longue ayant une longueur de cavité de 5λ ou plus et 20λ ou moins lorsqu'une longueur d'onde d'oscillation est λ.

7. Dispositif optique (3) comprenant :
le dispositif d'émission de lumière (4) selon l'une quelconque des revendications 1 à 6 ; et
une unité de réception de lumière (40) qui reçoit une première lumière réfléchie émise par la première source de lumière (10) du dispositif d'émission de lumière (4) et réfléchie par un objet à mesurer et une deuxième lumière réfléchie émise par la deuxième source de lumière (20) du dispositif d'émission de lumière (4) et réfléchie par l'objet à mesurer,
dans lequel l'unité de réception de lumière (40) émet un signal correspondant à un temps depuis l'émission de lumière de la première source de lumière (10) jusqu'à la réception de la lumière de la première source de lumière (10) par l'unité de réception de lumière (40), et un signal correspondant à un temps depuis l'émission de lumière de la deuxième source de lumière (20) jusqu'à la réception de la lumière de la deuxième source de lumière (20) par l'unité de réception de lumière (40).

8. Dispositif optique (3) comprenant :
le dispositif d'émission de lumière (4) selon l'une quelconque des revendications 1 à 6 ; et
une unité de réception de lumière (40) qui reçoit une première lumière réfléchie émise par la première source de lumière (10) du dispositif d'émission de lumière (4) et réfléchie par un objet à mesurer et une deuxième lumière réfléchie émise par la deuxième source de lumière (20) du dispositif d'émission de lumière (4) et réfléchie par l'objet à mesurer,
dans lequel la lumière est émise par la deuxième source de lumière (20) dans un cas où la première lumière réfléchie indique que l'objet à mesurer est présent à une distance prédéterminée.

9. Dispositif de traitement d'informations (1) comprenant :
le dispositif optique (3) selon la revendication 7 ou la revendication 8, et
une unité de spécification de forme (81) qui spécifie une forme tridimensionnelle de l'objet à mesurer sur la base d'une deuxième lumière réfléchie émise par la deuxième source de lumière (20) du dispositif optique (3) et réfléchie par l'objet à mesurer.

10. Dispositif de traitement d'informations (1) selon la revendication 9, comprenant en outre :
une unité de traitement d'authentification (91) qui effectue un traitement d'authentification lié à une utilisation du dispositif de traitement d'informations (1) sur la base d'un résultat de spécification par l'unité de spécification de forme (81).
